# EUROPEAN PATENT APPLICATION

(11) **EP 4 697 173 A1**
(43) Date of publication of application: **18.02.2026**
(21) Application number: 25190079.1
(22) Date of filing: 17.07.2025
(51) Int. Cl.: G06F 11/10

(54) **OPERATION METHOD OF NON-VOLATILE MEMORY, STORAGE DEVICE, AND OPERATION METHOD OF THE STORAGE DEVICE**

(30) Priority: 13.08.2024 KR 20240108496
(71) Applicant: Samsung Electronics Co., Ltd., Suwon-si, Gyeonggi-do 16677 (KR)
(72) Inventor: YI, Hyunju, 16677 Suwon-si (KR); SHIN, Dongmin, 16677 Suwon-si (KR); PARK, Ikkyun, 16677 Suwon-si (KR); JUN, Bohwan, 16677 Suwon-si (KR)
(74) Representative: Marks & Clerk LLP

(57) **Abstract**

An operation method of a storage device that includes a storage controller and a non-volatile memory device comprises generating a plurality of pieces of transmission parity data respectively corresponding to a plurality of data lines, transmitting, a write command, data, and the plurality of pieces of transmission parity data to a first non-volatile memory through the plurality of data lines, performing a transmission error detection operation with respect to each of the plurality of data lines, based on each of the plurality of pieces of transmission parity data, determining that re-training execution conditions are satisfied, based on an error detection result generated in the transmission error detection operation, and, in response to a state read command, when the re-training execution conditions are satisfied, transmitting state information indicating a transmission error state to the storage controller.

## Description

### TECHNICAL FIELD

The present invention generally relates to an operation method of a storage device including a storage controller and a non-volatile memory device, and to a storage device.

### BACKGROUND

Semiconductor memories are classified into volatile memory devices, such as static random-access memory (SRAM) and dynamic random-access memory (DRAM), which lose stored data when power is cut off, and non-volatile memory devices, such as flash memory devices, PRAM, MRAM, RRAM, and FRAM, which retain stored data even when power is cut off.

A storage device may include a non-volatile memory and a controller for controlling the non-volatile memory. Communication between a nonvolatile memory and a controller is performed at a low operating frequency, as compared to memory systems including high-speed memory, such as DRAM or SRAM. However, communication between a non-volatile memory and a controller is desired to be performed at high operating frequencies. Accordingly, various methods for aligning communication signals between a non-volatile memory and a controller are being introduced.

### SUMMARY

The present invention provides an operation method as defined by claim 1, and a storage device as defined by claim 15. Preferred embodiments are defined by the dependent claims.

According to an aspect of the present invention, there is provided an operation method of a storage device including a storage controller and a non-volatile memory device, the operation method including generating, by the storage controller, a plurality of pieces of transmission parity data respectively corresponding to a plurality of data lines, transmitting, by the storage controller and through the plurality of data lines, a write command, data, and the plurality of pieces of transmission parity data to a first non-volatile memory among a plurality of non-volatile memories, the plurality of non-volatile memories being included in the non-volatile memory device, performing, by the first non-volatile memory, a transmission error detection operation with respect to each of the plurality of data lines, based on each of the plurality of transmission parity data, determining, by the first non-volatile memory, that re-training execution conditions are satisfied, based on an error detection result generated in the transmission error detection operation, transmitting, by the storage controller, a state read command to the first non-volatile memory, and, in response to the state read command and based on the re-training execution conditions being satisfied, transmitting, by the first non-volatile memory, the state information indicating a transmission error state to the storage controller.

According to another aspect of the present invention, there is provided a storage device that includes a non-volatile memory device including a plurality of non-volatile memories, and a storage controller configured to generate a plurality of pieces of transmission parity data respectively corresponding to a plurality of data lines, transmit a write command, data, and the plurality of pieces of transmission parity data to a first non-volatile memory among the plurality of non-volatile memories through the plurality of data lines, and transmit a state read command to the first non-volatile memory. The first non-volatile memory is configure to perform a transmission error detection operation with respect to each of the plurality of data lines, based on each of the plurality of transmission parity data, determine that re-training execution conditions are satisfied, based on an error detection result generated in the transmission error detection operation, and, in response to the state read command and based on the re-training execution conditions being satisfied, transmit state information indicating a transmission error state to the storage controller.

The present disclosure is further directed to an operation method of a non-volatile memory, the operation method including receiving first sub-data and first sub-transmission parity data through a first data line and receiving second sub-data and second sub-transmission parity data through a second data line, performing a transmission error detection operation on the first sub-data, based on the first sub-transmission parity data and performing a transmission error detection operation on the second sub-data, based on the second sub-transmission parity data, determining that re-training execution conditions are satisfied, based on an error detection result generated in the transmission error detection operation, and, in response to a state read command and based on the re-training execution conditions being satisfied, outputting state information indicating a transmission error state through the first and second data lines.

### BRIEF DESCRIPTION OF THE DRAWINGS

Example implementations will be more clearly understood from the following detailed description, taken in conjunction with the accompanying drawings.
FIG. 1 is a block diagram of an example of a storage device according to some implementations.
FIG. 2 is a block diagram showing the storage device of FIG. 1 according to some implementations.
FIG. 3 is a block diagram showing an example of a storage controller of FIG. 1 according to some implementations.
FIG. 4 is a block diagram showing an example of a non-volatile memory of FIG. 1 according to some implementations.
FIG. 5 is a block diagram showing examples of an error detection circuit and a re-training determination circuit of FIG. 1 according to some implementations.
FIG. 6 is a flowchart of an example of operation of the storage device of FIG. 1 according to some implementations.
FIGS. 7A and 7B are drawings for explaining an example of a transmission error detection operation of a first non-volatile memory of FIG. 2 according to some implementations.
FIGS. 8A and 8B are drawings for explaining an example of a transmission error detection operation of the first non-volatile memory of FIG. 2 according to some implementations.
FIG. 9 is a flowchart of an example of operation of the first non-volatile memory of FIG. 2 according to some implementations.
FIG. 10 is a flowchart of an example of operation of the storage controller of FIG. 1 according to some implementations.
FIG. 11 is a flowchart showing an example of operation S320 of FIG. 10 according to some implementations.
FIG. 12 is a flowchart of an example of operation of the storage device of FIG. 2 according to some implementations.
FIG. 13 is a flowchart of an example of operation of the storage controller of FIG. 2 according to some implementations.
FIG. 14 is a flowchart of an example of operation of the storage device of FIG. 2 according to some implementations.
FIG. 15 is a flowchart of an example of operation of the storage device of FIG. 2 according to some implementations.
FIG. 16 is a flowchart of an example of operation of the storage device of FIG. 2 according to some implementations.
FIGS. 17A and 17B are drawings for explaining an example of a transmission error detection operation of the first non-volatile memory of FIG. 2 according to some implementations.

### DETAILED DESCRIPTION

In general, the present disclosure is directed toward a storage controller, a storage device, and an operation method of the storage device.

Hereinafter, example implementations will be explained in detail with reference to the accompanying drawings. In this regard, we note that the term "need", similarly e.g., "needs" or "needed", throughout this specification generally indicates an advantageous or desired, rather than necessarily essential, feature.

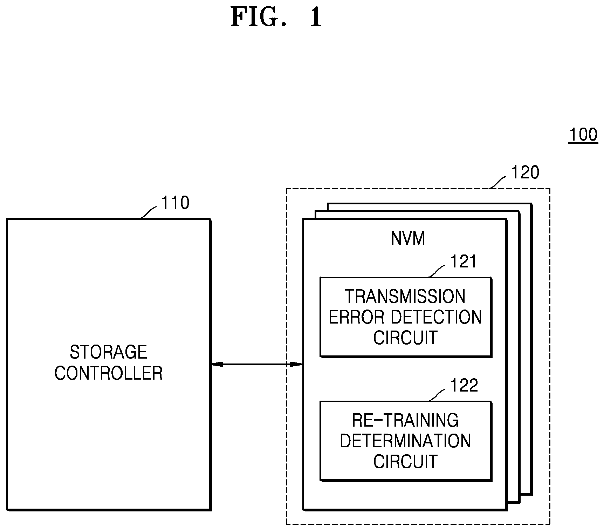

FIG. 1 is a block diagram of an example of a storage device according to according to some implementations.. In FIG. 1, a storage device 100 may include a storage controller 110 and a non-volatile memory device 120. According to some implementations, the storage device 100 may be a large-capacity storage medium, such as a solid state drive (SSD). The storage device 100 may be included in one of information processing devices configured to process various pieces of information and store processed information, such as a personal computer (PC), a laptop, a server, a workstation, a smartphone, a tablet PC, a digital camera, and a black box. However, embodiments are not limited thereto, and the storage device 100 may be implemented in various forms and may be included in various devices or various systems.

The storage controller 110 may be configured to control the non-volatile memory device 120. For example, the storage controller 110 may store data in the non-volatile memory device 120 or read data stored in the non-volatile memory device 120 under a control by an external host. According to some implementations, the storage controller 110 may perform various maintenance operations for improving the performance or reliability of the non-volatile memory device 120, independent of the control by the external host.

According to some implementations, the storage controller 110 may be configured to communicate with the external host, based on a pre-determined host interface. The pre-determined host interface may include at least one of various host interfaces, such as a Universal Serial Bus (USB), an multimedia card (MMC), a peripheral component Interconnection (PCI), a PCI-Express (PCI-E), Advanced Technology Attachment (ATA), Serial-ATA, Parallel-ATA, a small computer small interface (SCSI), an enhanced small disk interface (ESDI), an Integrated Drive Electronics (IDE), a Mobile Industry Processor Interface (MIPI), Nonvolatile Memory-express (NVM-e), and a Compute eXpress Link (CXL) interface.

According to some implementations, the storage controller 110 may be configured to communicate with the non-volatile memory device 120, based on a pre-determined memory interface. The pre-determined memory interface may include at least one of various flash memory interfaces, such as a toggle NAND interface and an Open NAND Flash Interface (ONFI).

For example, the storage controller 110 may transmit and receive various signals through signals of control signal lines CTRL and data lines DQ and a signal of a data strobe line DQS, in order to control the non-volatile memory device 120.

For example, a control signal CTRL, a signal of a data strobe line DQS, and signals of a plurality of data lines DQ may be provided to the non-volatile memory device 120 through different signal lines or different signal pins, respectively. The control signal CTRL and the signal of the data strobe line DQS may be signals for distinguishing signals (e.g., command CMD, address ADDR, or data DA) provided to the non-volatile memory device 120 through the signals of the plurality of data lines DQ. For example, the signal of the data line DQ indicates a signal transmitted and received through a data pin (DQ pin), and/or the signal of the data strobe line DQS indicates a signal transmitted and received through a data strobe pin (DQS pin).

The non-volatile memory device 120 may operate under a control by the storage controller 110. For example, the non-volatile memory device 120 may store data or output the stored data, under the control by the storage controller 110. The non-volatile memory device 120 may include a plurality of non-volatile memories NVM.

For example, a non-volatile memory NVM may distinguish whether a signal provided through the signals of the plurality of data lines DQ is a command CMD, an address ADDR, or data DATA, based on control signals CTRL. According to some implementations, various signals, such as a command latch enable signal CLE, an address latch enable signal ALE, a read enable signal RE/, or a write enable signal WE/, may be provided to the non-volatile memory NVM via the control signal lines CTRL.

The non-volatile memory NVM may be configured to identify (or capture) the data DATA provided via the signals of the plurality of data lines DQ, based on the signal of the data strobe line DQS. The non-volatile memory NVM may store the identified data DATA, based on the received command CMD and address ADDR.

For example, the non-volatile memory NVM may include a NAND flash memory. However, embodiments are not limited thereto, and the non-volatile memory device 120 may include at least one of volatile or non-volatile memories, such as static random access memory (SRAM), dynamic random access memory (DRAM), synchronous DRAM (SDRAM), read only memory (ROM), programmable ROM (PROM), electrically programmable ROM (EPROM), electrically erasable and programmable ROM (EEPROM), flash memory, phase-change RAM (PRAM), magnetic RAM (MRAM), resistive RAM (RRAM), ferroelectric RAM (FRAM), etc.

The storage device 100 may perform training (e.g., read training or write training) to increase the accuracy of communication when performing all functions. The storage device 100 may determine an alignment of the signals of the plurality of data lines DQ and a target delay of the signal of the data strobe line DQS. As a data input/output speed between the storage controller 110 and the non-volatile memory NVM increases, a re-training operation is needed, e.g., advantageous.

The non-volatile memory NVM and storage controller 110 may transmit and receive data through the plurality of data lines DQ. A delay on a path of the plurality of data lines DQ and the data strobe line DQS may vary with temperature changes. When a sampling timing changes due to the delay variation, a setup/hold (S/H) margin may be reduced. The storage controller 110 may perform re-training to compensate for the delay variation with temperature changes. Accordingly, the storage controller 110 may adjust the delay on the path. However, when re-training is performed, resources used for training may increase.

For example, the storage controller 110 may periodically collect temperature information or voltage information of a plurality of non-volatile memories NVM. In some implementations, the storage controller 110 may periodically transmit an oscillator request command to the plurality of non-volatile memories NVM. The storage controller 110 may periodically request for an oscillator value of a data strobe signal. The storage controller 110 may monitor each of the plurality of non-volatile memories NVM. The monitoring may indicate an operation of monitoring a delay change on the path of the plurality of data lines DQ and the data strobe line DQS. The storage controller 110 may determine a re-training time of the non-volatile memory NVM through the monitoring. Accordingly, the performance of the storage device 100 may be degraded.

The storage device 100 may determine a re-training time while performing a normal operation. The storage device 100 may determine when to perform re-training through a write operation, without a monitoring operation. In some implementations, the storage device 100 may determine when to perform re-training through a write operation, together with a monitoring operation.

The storage controller 110 generates pieces of transmission parity data for each of the plurality of data lines DQ. The storage controller 110 transmits the pieces of transmission parity data together with data to the non-volatile memory NVM. According to some implementations, the storage controller 110 may transmit the data, the memory parity data, and the transmission parity data to the non-volatile memory NVM. The memory parity data may indicate parity data used to improve memory cell reliability. The transmission parity data may indicate parity data used to address a transmission error.

The non-volatile memory NVM performs a transmission error detection operation, based on the transmission parity data. The non-volatile memory NVM may determine the conditions for performing re-training, based on a result of the transmission error detection operation. When the non-volatile memory NVM determines that re-training is necessary, based on an error detection result, the non-volatile memory NVM may provide notification of this to the storage controller 110.

The non-volatile memory NVM may include a transmission error detection circuit 121 and a re-training determination circuit 122. The transmission error detection circuit 121 may perform a transmission error detection operation with respect to each of the plurality of data lines DQ, based on the transmission parity data. The transmission error detection circuit 121 may determine whether there is an error in sub-data received from each of the plurality of data lines DQ. The transmission error detection circuit 121 may generate the error detection result.

The re-training determination circuit 122 may determine whether the re-training conditions are satisfied, based on the error detection result. For example, the re-training determination circuit 122 may determine whether the re-training conditions are satisfied, by comparing the number of data lines from which transmission errors are detected with a threshold value. In response to a state read command, the non-volatile memory NVM may transmit state information indicating a transmission error state to the storage controller 110.

Accordingly, the storage device 100 may not perform a monitoring operation of periodically monitoring temperature/voltage changes of a plurality of non-volatile memories NVM. The non-volatile memory NVM detects an error, based on the transmission parity data. The non-volatile memory NVM notifies the transmission error state to the storage controller 110, through the state information. The storage device 100 may perform re-training without performance degradation.

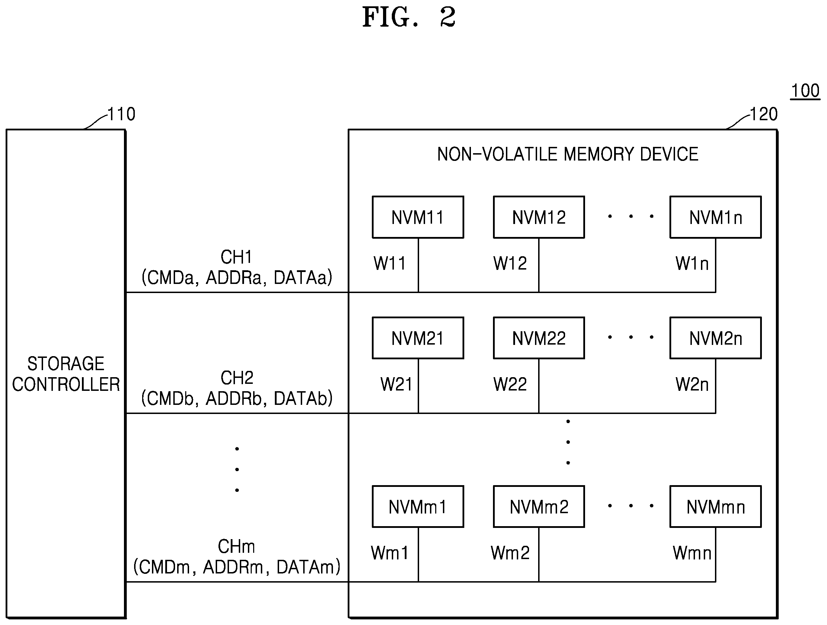

FIG. 2 is a block diagram showing the storage device 100 of FIG. 1 according to some implementations. In FIGS. 1 and 2, the storage device 100 includes the non-volatile memory device 120 and the storage controller 110. The storage device 100 may support a plurality of channels CH1 through CHm, and the nonvolatile memory device 120 and the storage controller 110 may be connected to each other through the plurality of channels CH1 through CHm. For example, the storage device 100 may be implemented as a storage device such as an SSD.

The non-volatile memory device 120 includes a plurality of non-volatile memories NVM11 through NVMmn. Each of the plurality of non-volatile memories NVM11 through NVMmn may correspond to the non-volatile memory NVM of FIG. 1. Each of the plurality of non-volatile memories NVM11 through NVMmn may be connected to one of the plurality of channels CH1 through CHm through a corresponding way. For example, non-volatile memories NVM11 through NVM1n may be connected to a first channel CH1 through ways W11 through W1n, and non-volatile memories NVM21 through NVM2n may be connected to a second channel CH2 through ways W21 through W2n. According to some implementations, each of the non-volatile memories NVM11 through NVMmn may be implemented as an arbitrary memory unit that may operate according to an individual command from the storage controller 110. For example, each of the non-volatile memories NVM11 through NVMmn may be implemented as a chip or a die, but embodiments are not limited thereto.

The storage controller 110 may transmit and receive signals to and from the non-volatile memory device 120 through the plurality of channels CH1 through CHm. For example, the storage controller 110 may transmit commands CMDa through CMDm, addresses ADDRa through ADDRm, and data DATAa through DATAm to the non-volatile memory device 120 through the plurality of channels CH1 through CHm, or may receive the data DATAa through DATAm from the non-volatile memory device 120.

The storage controller 110 may select one of the non-volatile memory devices connected to each channel through each channel, and may transmit and receive signals to and from the selected non-volatile memory device. For example, the storage controller 110 may select the non-volatile memory NVM11 from among the non-volatile memories NVM11 through NVM1n connected to the first channel CH1. The storage controller 110 may transmit the command CMDa, the address ADDRa, and the data DATAa to the selected non-volatile memory NVM11 through the first channel CH1, or may receive the data DATAa from the selected non-volatile memory NVM11.

The storage controller 110 may transmit and receive signals to and from the non-volatile memory device 120 through different channels in parallel. For example, the storage controller 110 may transmit a command CMDb to the non-volatile memory device 120 through a second channel CH2 while transmitting the command CMDa to the non-volatile memory device 120 through the first channel CH1. For example, the storage controller 110 may receive data DATAb from the non-volatile memory device 120 through the second channel CH2 while receiving the data DATAa from the non-volatile memory device 120 through the first channel CH1.

According to some implementations, the storage controller 110 may perform a read operation or a write operation on a second non-volatile memory NVM21 connected to the second channel CH2 while performing a re-training operation on the first non-volatile memory NVM11 connected to the first channel CH1.

The storage controller 110 may control overall operations of the non-volatile memory device 120. The storage controller 110 may control each of the non-volatile memories NVM11 through NVMmn connected to the channels CH1 through CHm by transmitting a signal to the channels CH1 through CHm. For example, the storage controller 110 may control one non-volatile memory selected from the non-volatile memories NVM11 through NVM1n by transmitting the command CMDa and the address ADDRa to the first channel CH1.

Each of the non-volatile memories NVM11 through NVMmn may operate under a control by the storage controller 110. For example, the non-volatile memory NVM11 may program the data DATAa according to the command CMDa, the address ADDRa, and the data DATAa provided to the first channel CH1. For example, the non-volatile memory NVM21 may read the data DATAb according to the command CMDb and the address ADDRb provided to the second channel CH2, and may transmit the read-out data DATAb to the storage controller 110.

In FIG. 2, the non-volatile memory device 120 is illustrated as communicating with the storage controller 110 through m channels and including n non-volatile memory devices in correspondence with each channel. However, the number of channels and the number of non-volatile memory devices connected to one channel may vary.

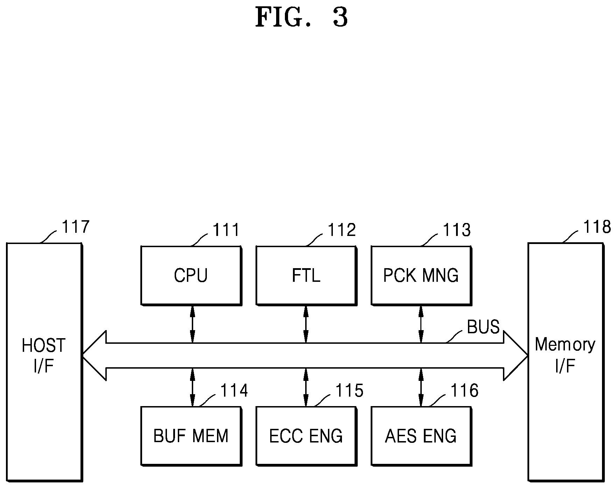

FIG. 3 is a block diagram showing the storage controller 110 of FIG. 1 according to some implementations. In FIGS. 1 and 3, the storage controller 110 may include a central processing unit (CPU) 111, a host interface circuit 117, and/or an NVM interface circuit 118. The storage controller 110 may further include a flash translation layer (FTL) 112, a packet manager 113, a buffer memory 114, an error correction code (ECC) engine 115, and/or an advanced encryption standard (AES) engine 116. The storage controller 110 may further include a working memory (not shown) into which the FTL 112 is loaded, and the CPU 111 may control data writing and reading operations with respect to a non-volatile memory device by executing the FTL 112.

According to some implementations, the host interface circuit 117 may include at least one of various interfaces, such as a Double Data Rate (DDR), a Low-Power DDR (LPDDR), a Universal Serial Bus (USB), an multimedia card (MMC), a peripheral component Interconnection (PCI), a PCI-Express (PCI-E), Advanced Technology Attachment (ATA), Serial-ATA, Parallel-ATA, a small computer small interface (SCSI), an enhanced small disk interface (ESDI), an Integrated Drive Electronics (IDE), a Mobile Industry Processor Interface (MIPI), Nonvolatile Memory-express (NVM-e), and a Universal Flash Storage (UFS).

The host interface circuit 117 may transmit and receive a packet to and from a host (not shown). The packet transmitted from the host to the host interface circuit 117 may include, for example, data to be written to the non-volatile memory device 120 or a command, and the packet transmitted from the host interface circuit 117 to the host may include, for example, a response to the command or data read from the non-volatile memory device 120. The NVM interface circuit 118 may transmit the data to be written to the non-volatile memory device 120 to the non-volatile memory device 120, or may receive the data read from the non-volatile memory device 120. The NVM interface circuit 118 may be implemented to comply with a standard, such as Toggle or ONFI.

The FTL 112 may perform several functions, such as address mapping, wear-leveling, and/or garbage collection. The address mapping is an operation of changing a logical address received from the host into a physical address used to actually store data in the non-volatile memory device 120. The wear-leveling is a technology for preventing excessive deterioration of a specific block by enabling blocks within the non-volatile memory device 120 to be used uniformly, and may be implemented, for example, through firmware technology of balancing erase counts of physical blocks. The garbage collection is a technology for securing an available capacity within the non-volatile memory device 120 by using a method of copying valid data of a block to a new block and then erasing the existing block.

The packet manager 113 may create a packet according to the protocol of an interface agreed with the host, or parse various types of information from a packet received from the host. The buffer 114 may temporarily store data that is to be written to the non-volatile memory device 120 or data read from the non-volatile memory device 120. The buffer memory 114 may be configured to be provided within the storage controller 110, but may also be placed outside the storage controller 110.

The ECC engine 115 may perform error detection and correction functions with respect to read-out data read from the non-volatile memory device 120. In more detail, the ECC engine 115 may generate parity bits for write data that is to be written to the non-volatile memory device 120, and the generated parity bits may be stored in the non-volatile memory device 120, together with the write data. When reading data from the non-volatile memory device 120, the ECC engine 115 may correct errors in the read-out data by using the parity bits read from the non-volatile memory device 120 together with the read-out data, and may output read-out data of which errors has been corrected.

According to some implementations, the ECC engine 115 may generate memory parity data. The ECC engine 155 may generate the memory parity data to detect errors included in the data read from the non-volatile memory NVM. The ECC engine 155 may use the memory parity data to complement memory cell reliability.

According to some implementations, the ECC engine 115 may generate transmission parity data. The ECC engine 115 may divide data (or user data or page data) by the number of data lines. The ECC engine 115 may divide the data into a plurality of pieces of sub-data. The ECC engine 115 may generate sub-transmission parity data for each of the plurality of pieces of sub-data. The transmission parity data may be used to compensate for a channel error or a transmission error.

The AES engine 116 may perform at least one of an encryption operation and a decryption operation on data input to the storage controller 110, by using a symmetric key algorithm.

As an input/output speed between the storage controller 110 and the non-volatile memory NVM increases, the range of a valid window may decrease. A channel error rate may increase during data transmission. During initialization, training may be performed to ensure a maximum margin within the valid window. However, temperature and voltage changes of the non-volatile memory NVM may increase during an input/output operation. Accordingly, a skew may occur between the signals of the plurality of data lines DQ and the signal of the data strobe line DQS. Due to the skew, the non-volatile memory NVM may store data including an error. Although the reliability of a memory cell is good (i.e., the memory cell maintains a normal distribution), data including errors may be stored in a pattern that causes UECC in a read operation, due to channel transmission errors. Accordingly, re-training may be needed, e.g., advantageous.

According to some implementations, the storage controller 110 may monitor temperature and voltage changes of the non-volatile memory NVM in order to determine whether to perform re-training. The storage controller 110 may request the non-volatile memory NVM for an oscillator value of a data strobe signal. The storage controller 110 may request the non-volatile memory NVM for delay information of the data strobe signal. Alternatively, the storage controller 110 may request the non-volatile memory NVM for a DQS/DQ phase variation.

According to some implementations, a sufficient time may be needed to increase the accuracy of an oscillator request command. The storage controller 110 may also perform a monitoring operation (or a polling operation) of periodically transmitting the oscillator request command even to the non-volatile memory NVM that does not need re-training. Accordingly, the performance of the storage device 100 may be degraded. In other words, as the storage controller 110 periodically transmits an oscillator command, an input/output performance may decrease. In other words, a sequential performance and QOS latency of the storage device 100 may decrease.

According to some implementations, the storage controller 110 may determine the re-training time. The storage controller 110 may determine whether re-training is needed for each of the plurality of non-volatile memories NVM. The storage controller 110 may determine whether re-training is needed, based on state information indicating a transmission error state. The storage controller 110 may perform re-training on the non-volatile memory NVM, in response to the state information indicating a transmission error state. The storage controller 110 may determine, based on state information, whether a program failure is due to a memory cell error or a channel transmission error. Accordingly, storage device(100) may detect a channel error between the storage controller 110 and the non-volatile memory NVM in real time substantially (e.g. completely) without performance degradation.

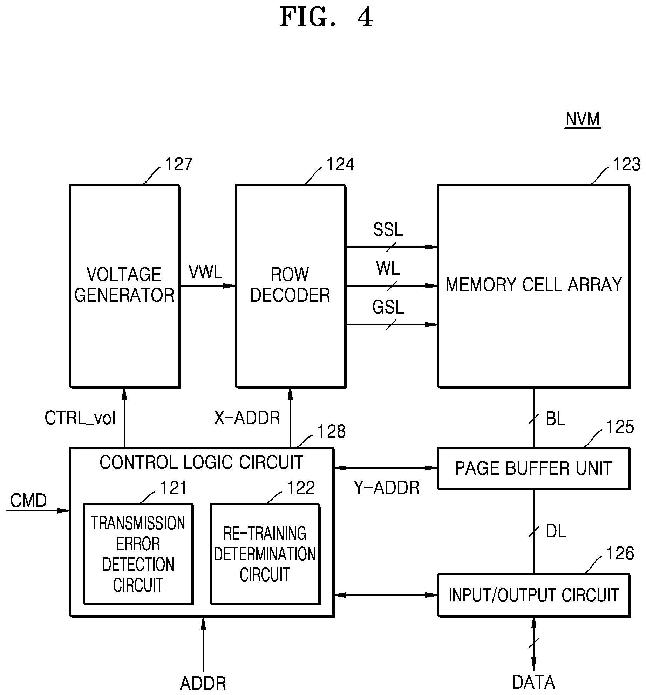

FIG. 4 is a block diagram showing the non-volatile memory NVM of FIG. 1 according to some implementations. In FIG. 4,the non-volatile memory NVM may correspond to the plurality of non-volatile memories NVM11 through NVMmn of FIG. 2. In FIGS. 1 and 4, the non-volatile memory NVM may include a memory cell array 123, a row decoder 124, a page buffer unit 125, an input/output circuit 126, a voltage generator 127, and/or a control logic circuit 128. Additionally, the non-volatile memory NVM may further include a column logic, a pre-decoder, a temperature sensor, a command decoder, an address decoder, and/or the like. According to some implementations, the non-volatile memory NVM may be a non-volatile memory device, such as a NAND flash memory device. However, embodiments are not limited thereto.

For example, the memory cell array 123 may be a core of the non-volatile memory NVM. The row decoder 124, the page buffer circuit 125, the input/output circuit 126, and/or the control logic circuit 128 may be a peripheral circuit of the non-volatile memory NVM. The peripheral circuit may be configured to access the core.

The memory cell array 123 may include a plurality of memory blocks. Each of the plurality of memory blocks may include a plurality of memory cells. The memory cell array 123 may be connected to the page buffer circuit 125 via bit lines BL, and may be connected to the row decoder 124 via word lines WL, string select lines SSL, and ground select lines GSL.

According to some implementations, the memory cell array 123 may include a three-dimensional (3D) memory cell array, and the 3D memory cell array may include a plurality of strings. Each of the plurality of strings may include memory cells respectively connected to word lines stacked vertically on a substrate.

The row decoder 124 may receive a row address X-ADDR from the control logic circuit 128. The row decoder 124 may decode the row address X-ADDR, and, based on a result of the decoding, may control or drive voltages of the string select lines SSL, the word lines WL, and the ground select lines GSL. For example, the row decoder 124 may provide operating voltages corresponding to the string select lines SSL, the word lines WL, and the ground select lines GSL, respectively, based on a result of the decoding.

In response to the row address X-ADDR, the row decoder 124 may select one word line from the plurality of word lines WL and select one string select line from the plurality of string select lines SSL. For example, the row decoder 360 may apply a program voltage and a program verify voltage to the selected word line during a program operation, and may apply a read voltage to the selected word line during a read operation.

The page buffer circuit 125 may be connected to the memory cell array 123 via the bit lines BL. The page buffer circuit 125 may select at least one bit line from the bit lines BL in response to a column address Y-ADDR. The page buffer circuit 125 may operate as a write driver or a sense amplifier according to an operation mode. For example, the page buffer circuit 125 may receive the data DATA from the input/output circuit 126, and may temporarily store the received data DATA. The page buffer circuit 125 may control the voltage of the bit lines BL so that the temporarily stored data DATA is stored in the memory cell array 123. In some implementations, the page buffer circuit 125 may read the data DATA from the memory cell array 123 by detecting a change in the voltage of the bit lines BL. The page buffer circuit 125 may transmit the read-out data DATA to the input/output circuit 126.

The input/output circuit 126 may exchange the data DATA with an external device (e.g., a storage controller). According to some implementations, the input/output circuit 126 may output the data DATA to the external device or receive the data DATA from the external device, in synchronization with a data strobe signal.

The voltage generator 127 may generate various types of voltages for performing program, read, and/or erase operations, based on a voltage control signal CTRL_vol. For example, the voltage generator 127 may generate a program voltage, a read voltage, a program verify voltage, and/or an erase voltage, etc. as word line voltages VWL.

The control circuit 128 may provide overall control of various operations within the non-volatile memory NVM. The control logic circuit 128 may output various control signals in response to the command CMD and/or the address ADDR from the storage controller 110. For example, the control logic circuit 128 may output the voltage control signal CTRL_vol, the row address X-ADDR, and the column address Y-ADDR.

The control logic circuit 128 may include the transmission error detection circuit 121 and the re-training determination circuit 122. The transmission error detection circuit 121 may perform a transmission error detection operation. The transmission error detection circuit 121 may perform a decoding operation, based on the received transmission parity data. The transmission error detection circuit 121 may detect an error in each of the pieces of sub-data, by using the transmission parity data. The transmission error detection circuit 121 may detect an error, with respect to the sub-data corresponding to each of the plurality of data lines DQ. The transmission error detection circuit 121 may determine the number of errors included in the sub-data.

For example, the error detection circuit 121 may determine whether the sub-data includes a '1' bit error, a '2' bit error, or an error of '3' bits or more. The transmission error detection circuit 121 may generate an error detection result. The transmission error detection circuit 121 may generate transmission error information, based on the error detection result. The transmission error detection circuit 121 may generate the transmission error information by accumulating error detection results. The transmission error detection circuit 121 may transmit, to the storage controller 110 through the transmission error information, information about whether an error has been detected for each of the plurality of data lines and information about the number of errors for each of the plurality of data lines.

The re-training determination circuit 122 may determine whether the re-training of the non-volatile memory NVM is necessary, based on the error detection result. The re-training determination circuit 122 may determine whether the re-training conditions are satisfied, based on the error detection result. For example, when the number of data lines from which errors have been detected is greater than or equal to the threshold value, the re-training determination circuit 122 may determine whether the re-training conditions are satisfied. However, embodiments are not limited thereto, and re-training conditions may be combined in various ways.

For example, the re-training determination circuit 122 may determine whether the re-training conditions are satisfied, by synthesizing a plurality of error detection results. The re-training determination circuit 122 may determine whether the re-training conditions are satisfied, based on the number of errors included in the sub-data. The re-training conditions may correspond to conditions under which UECC occurs.

According to some implementations, the non-volatile memory NVM may generate state information, based on a result of the determination made by the re-training determination circuit 122. For example, when the re-training conditions are met, the non-volatile memory NVM may notify the storage controller 110 that re-training is needed, through the status information indicating a transmission error state.

As described above, the non-volatile memory NVM may detect an error during every write operation, based on the transmission parity data. The non-volatile memory NVM may notify the transmission error state to the storage controller 110. Accordingly, the non-volatile memory NVM may not store data including a transmission error, and may immediately recover data.

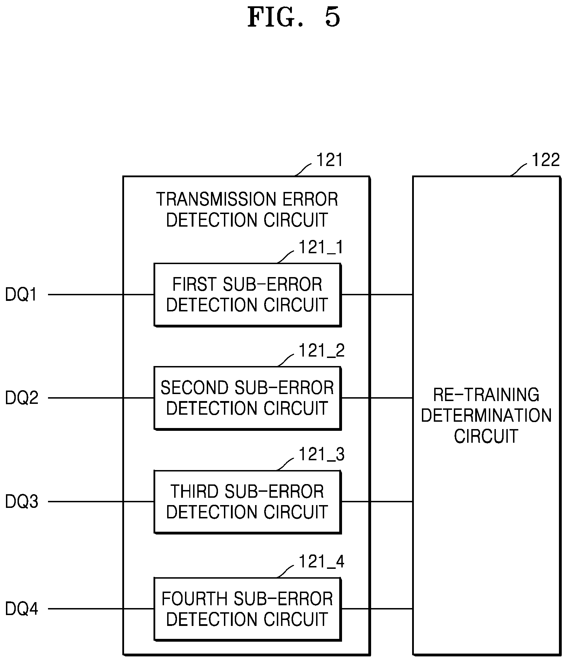

FIG. 5 is a block diagram showing examples of an the error detection circuit and a re-training determination circuit of FIG. 1 according to some implementations. In FIG. 5, the non-volatile memory NVM may include the transmission error detection circuit 121 and the re-training determination circuit 122. The error detection circuit 121 may include first, second, third, and fourth sub-error detection circuits 121_1, 121_2, 121_3, and 121_4. However, embodiments are not limited thereto, and the number of sub-error detection circuits included in an error detection circuit may be reduced or increased according to implementations.

Each of the first through fourth sub-error detection circuits 121_1 through 121_4 may receive data transmitted through a corresponding line. For example, the first sub-error detection circuit 121_1 may receive data transmitted through a first data line DQ1. The second sub-error detection circuit 121_2 may receive data transmitted through a second data line DQ2. The third sub-error detection circuit 121_3 may receive data transmitted through a third data line DQ3. The fourth sub-error detection circuit 121_4 may receive data transmitted through a fourth data line DQ4.

Each of the first through fourth sub-error detection circuits 121_1 through 121_4 may perform a transmission error detection circuit. Each of the first through fourth sub-error detection circuits 121_1 through 121_4 may detect an error for received data. Each of the first through fourth sub-error detection circuits 121_1 through 121_4 may detect an error in sub-data, based on sub-transmission parity data.

For example, the first sub-error detection circuit 121_1 may detect an error for the data received through the first data line DQ1. The second sub-error detection circuit 121_2 may detect an error for the data received through the second data line DQ2. The third sub-error detection circuit 121_3 may detect an error for the data received through the third data line DQ3. The fourth sub-error detection circuit 121_4 may detect an error for the data received through the fourth data line DQ4.

The transmission error detection circuit 121 may generate an error detection result. The error detection result may include e.g. first, second, third, and/or fourth sub-results. The first sub-error detection circuit 121_1 may generate a first sub-result, the second sub-error detection circuit 121_2 may generate a second sub-result, the third sub-error detection circuit 121_3 may generate a third sub-result, and the fourth sub-error detection circuit 121_4 may generate a fourth sub-result. The transmission error detection circuit 121 may transmit the error detection result to the re-training determination circuit 122.

The re-training determination circuit 122 may receive an error detection result. The re-training determination circuit 122 may receive a threshold value. The storage controller 110 may set the threshold value through a threshold value setting command. The threshold value may be a predetermined value. The re-training determination circuit 122 may store the threshold value. The re-training determination circuit 122 may determine whether the re-training conditions are satisfied, based on the error detection result and the threshold value. The re-training determination circuit 122 may generate a result of the determination. The re-training determination circuit 122 may transmit the result of the determination to the control logic circuit 128. The control logic circuit 128 may generate state information, based on the result of the determination.

As described above, the non-volatile memory NVM may perform a transmission error detection operation. The non-volatile memory NVM may notify the storage controller 110 of whether re-training is necessary. Accordingly, the storage device 100 may remove an overhead of determining periodically whether re-training is necessary. In other words, the storage controller 110 may not transmit a separate command for confirming a temperature/voltage change to each of a plurality of non-volatile memories NVM. The storage device 100 may prevent performance degradation.

An operation of the first non-volatile memory NVM11 described below is applicable to the plurality of non-volatile memories NVM included in the non-volatile memory device 120 of FIG. 1. The plurality of non-volatile memories NVM may perform an operation of the first non-volatile memory NVM11 described below. For example, each of the plurality of non-volatile memories NVM may perform a transmission error detection operation.

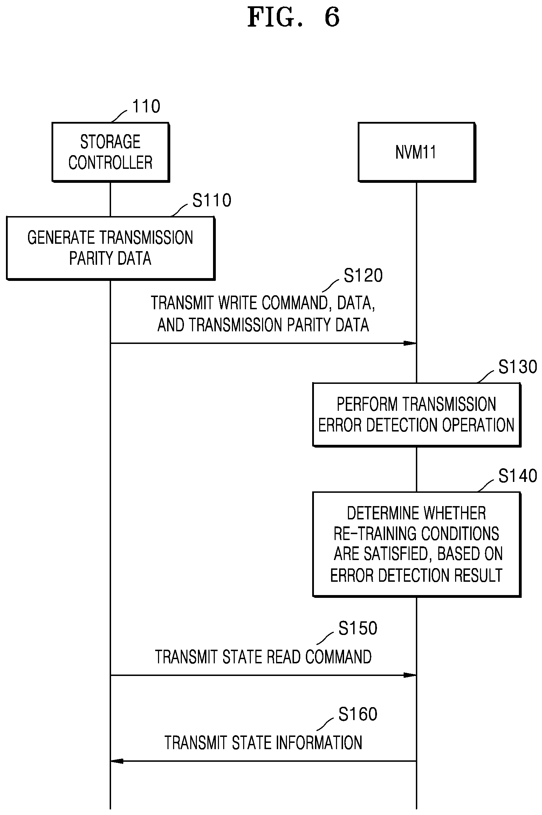

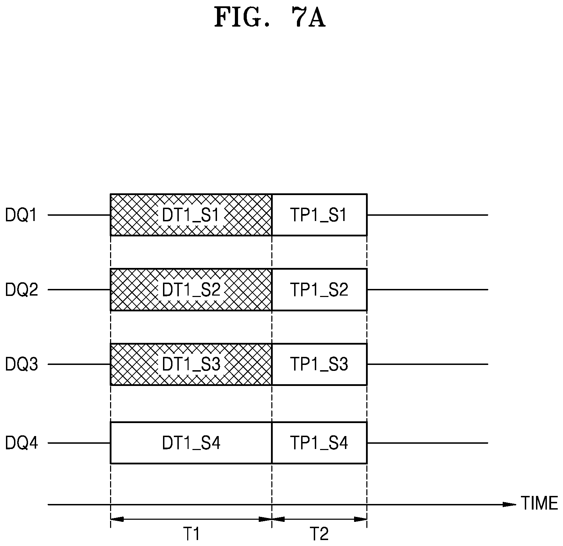

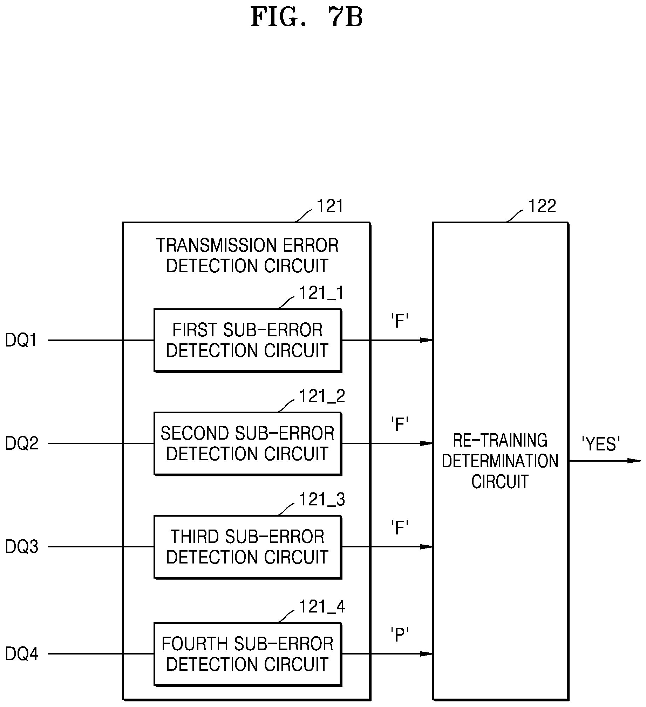

FIG. 6 is a flowchart of an example of operation of the storage device 100 of FIG. 1 according to some implementations. FIGS. 7A and 7B are drawings for explaining an example of a transmission error detection operation of the first non-volatile memory NVM11 of FIG. 2 according to some implementations.

FIGS. 7A and 7B illustrate a case where the re-training conditions are met. Referring to FIGS. 2, 6, 7A, and 7B, the storage controller 110 may communicate with the first non-volatile memory NVM11 among the plurality of nonvolatile memories NVM11 through NVMmn. The storage controller 110 may perform a write operation with respect to the first non-volatile memory NVM11. The storage controller 110 may store data in the first non-volatile memory NVM11. For example, the storage controller 110 may perform a write operation with respect to the first non-volatile memory NVM11, in response to a write request of an external host device (not shown).

The storage controller 110 may determine whether re-training with respect to the first non-volatile memory NVM11 is necessary, through the write operation. The storage controller 110 may determine whether to perform re-training with respect to the first non-volatile memory NVM11 by performing a general write operation, without a separate monitoring operation (or a polling operation). In some implementations, the storage controller 110 may determine whether to perform re-training with respect to the first non-volatile memory NVM11 by performing a general write operation, together with a monitoring operation.

In operation S110, the memory controller 110 may generate transmission parity data TP1. The storage controller 110 may generate the transmission parity data TP1, based on data DT1. The storage controller 110 may divide the data DT1 into first, second, third, and fourth sub-data DT1_S1, DT1_S2, DT1_S3, and DT1_S4. The data DT1 may include the first, second, third, and fourth sub-data DT1_S1, DT1_S2, DT1_S3, and DT1_S4. The transmission parity data TP1 may include first, second, third, and fourth sub-transmission parity data TP1_S1, TP1_S2, TP1_D3, and TP1_S4.

According to some implementations, the storage controller 110 may divide the data DT1 by the number of data lines DQ. The storage controller 110 may divide the data DT1 into pieces of sub-data having the same size by the number of data lines DQ. For example, the storage controller 110 may divide the data DT1 into the first, second, third, and fourth sub-data DT1_S1, DT1_S2, DT1_S3, and DT1_S4. The first through fourth sub-data DT1_S1 through DT1_S4 may have the same sizes.

For example, the first sub-data DT1_S1 may correspond to the first data line DQ1, the second sub-data DT1_S2 may correspond to the second data line DQ2, the third sub-data DT1_S3 may correspond to the third data line DQ3, and the fourth sub-data DT1_D4 may correspond to the fourth data line DQ4. The first sub-data DT1_S1 may be a first portion of the data DT1, the second sub-data DT1_S2 may be a second portion of the data DT1, the third sub-data DT1_S3 may be a third portion of the data DT1, and the fourth sub-data DT1_S4 may be a fourth portion of the data DT1.

According to some implementations, the storage controller 110 may generate the transmission parity data TP1, based on the data DT1. For example, the storage controller 110 may generate the first sub-transmission parity data TP1_S1, based on the first sub-data DT1_S1. The storage controller 110 may generate the second sub-transmission parity data TP1_S2, based on the second sub-data DT1_S2. The storage controller 110 may generate the third sub-transmission parity data TP1_S3, based on the third sub-data DT1_S3. The storage controller 110 may generate the fourth sub-transmission parity data TP1_S4, based on the fourth sub-data DT1_S4.

For example, the first sub-transmission parity data TP1_S1 may correspond to the first sub-data DT1_S1. The second sub-transmission parity data TP1_S2 may correspond to the second sub-data DT1_S2. The third sub-transmission parity data TP1_S3 may correspond to the third sub-data DT1_S3. The fourth sub-transmission parity data TP1_S4 may correspond to the fourth sub-data DT1_S4.

In operation S120, the storage controller 110 transmits a write command, the data DT1, and the transmission parity data TP1 to the non-volatile memory NVM. The data DT1 may be data corresponding to the write command. For example, the data DT1 may be user data.

The storage controller 110 may transmit the first sub-data DT1_S1 through the first data line DQ1 during a first period T1. The storage controller 110 may transmit the second sub-data DT1_S2 through the second data line DQ2 during the first period T1. The storage controller 110 may transmit the third sub-data DT1_S3 through the third data line DQ3 during the first period T1. The storage controller 110 may transmit the fourth sub-data DT1_S4 through the fourth data line DQ4 during the first period T1.

The storage controller 110 may transmit the first sub-transmission parity data TP1_S1 through the first data line DQ1 during a second period T2. The storage controller 110 may transmit the second sub-transmission parity data TP1_S2 through the second data line DQ2 during the second period T2. The storage controller 110 may transmit the third sub-transmission parity data TP1_S3 through the third data line DQ3 during the second period T2. The storage controller 110 may transmit the fourth sub-transmission parity data TP1_S4 through the fourth data line DQ4 during the second period T2.

The first non-volatile memory NVM11 may receive the first sub-data DT1_S1 and the first sub-transmission parity data TP1_S1 through the first data line DQ1. The first non-volatile memory NVM11 may receive the second sub-data DT1_S2 and the second sub-transmission parity data TP1_S2 through the second data line DQ2. The first non-volatile memory NVM11 may receive the third sub-data DT1_S3 and the third sub-transmission parity data TP1_S3 through the third data line DQ3. The first non-volatile memory NVM11 may receive the fourth sub-data DT1_S4 and the fourth sub-transmission parity data TP1_S4 through the fourth data line DQ4.

For example, data received by the non-volatile memory NVM may include an error due to skews of a signal of the data line DQ and a signal of the data strobe line DQS. In other words, due to a transmission error, data transmitted by the storage controller 110 and data received by the first non-volatile memory NVM11 may be different from each other. For example, it is assumed that the first through third sub-data DT1_S1 through DT1_S3 received by the first non-volatile memory NVM11 include errors and the fourth sub-data DT1_S4 received by the first non-volatile memory NVM11 does not include errors.

In operation S130, the first non-volatile memory NVM11 may perform a transmission error detection operation. The first non-volatile memory NVM11 may detect an error of the data DT1, based on the transmission parity data TP1. The first non-volatile memory NVM11 may detect a transmission error for each of the plurality of data lines DQ.

For example, the first sub-error detection circuit 121_1 may receive the first sub-data DT1_S1 and the first sub-transmission parity data TP1_S1. The second sub-error detection circuit 121_2 may receive the second sub-data DT1_S2 and the second sub-transmission parity data TP1_S2. The third sub-error detection circuit 121_3 may receive the third sub-data DT1_S3 and the third sub-transmission parity data TP1_S3. The fourth sub-error detection circuit 121_4 may receive the fourth sub-data DT1_S4 and the fourth sub-transmission parity data TP1_S4.

Each of the first through fourth sub-error detection circuits 121_1 through 121_4 may perform a transmission error detection operation. The first sub-error detection circuit 121_1 may detect an error of the first sub-data DT1_S1, based on the first sub-transmission parity data TP1_S1. The second sub-error detection circuit 121_2 may detect an error of the second sub-data DT1_S2, based on the second sub-transmission parity data TP1_S2. The third sub-error detection circuit 121_3 may detect an error of the third sub-data DT1_S3, based on the third sub-transmission parity data TP1_S3. The fourth sub-error detection circuit 121_4 may detect an error of the fourth sub-data DT1_S4, based on the fourth sub-transmission parity data TP1_S4.

The transmission error detection circuit 121 may generate an error detection result. The transmission error detection circuit 121 may transmit the error detection result to the re-training determination circuit 122. An error detection result may include first, second, third, and fourth sub-results SR1, SR2, SR3, and SR4. The error detection result may include information about whether an error is detected, information about the number of errors included in the data, etc. The first sub-result SR1 may be generated by the first sub-error detection circuit 121_1, the second sub-result SR2 may be generated by the second sub-error detection circuit 121_2, the third sub-result SR3 may be generated by the third sub-error detection circuit 121_3, and the fourth sub-result SR4 may be generated by the fourth sub-error detection circuit 121_4. Each of the first through fourth sub-results SR1 through SR4 may indicate an error detection result for each of pieces of corresponding sub-data. For example, the first sub-result SR1 may indicate an error detection result for the first sub-data DT1_S1.

Because the first sub-data DT1_S1 includes an error, the first sub-error detection circuit 121_1 may detect an error from the first sub-data DT1_S1, based on the first sub-transmission parity data TP1_S1. In other words, the first sub-error detection circuit 121_1 may determine that an error exists in the first sub-data DT1_S1. The first sub-error detection circuit 121_1 may generate the first sub-result SR1 indicating a first value (e.g., 'F'). For example, the first value may indicate that there is an error. A second value (e.g., 'P') may indicate that there are no errors.

Because the second sub-data DT1_S2 includes an error, the second sub-error detection circuit 121_2 may determine that an error exists in the second sub-data DT1_S2, based on the second sub-transmission parity data TP1_S2. The second sub-error detection circuit 121_2 may generate the second sub-result SR2 indicating the first value (e.g., 'F'). Because the third sub-data DT1_S3 includes an error, the third sub-error detection circuit 121_3 may determine that an error exists in the third sub-data DT1_S3, based on the third sub-transmission parity data TP1_S3. The third sub-error detection circuit 121_3 may generate the third sub-result SR3 indicating the first value (e.g., 'F'). Because the fourth sub-data DT1_S4 includes no errors, the fourth sub-error detection circuit 121_4 may determine that no errors exist in the fourth sub-data DT1_S4, based on the fourth sub-transmission parity data TP1_S4. The fourth sub-error detection circuit 121_4 may generate the fourth sub-result SR4 indicating the second value (e.g., 'F').

The transmission error detection circuit 121 may transmit the error detection result to the re-training determination circuit 122. The first sub-error detection circuit 121_1 may transmit the first sub-result SR1 to the re-training determination circuit 122. The second sub-error detection circuit 121_2 may transmit the second sub-result SR2 to the re-training determination circuit 122. The third sub-error detection circuit 121_3 may transmit the third sub-result SR3 to the re-training determination circuit 122. The fourth sub-error detection circuit 121_4 may transmit the fourth sub-result SR4 to the re-training determination circuit 122.

In operation S140, the first non-volatile memory NVM11 may determine whether the re-training conditions are satisfied, based on the error detection. The re-training determination circuit 122 may receive the error detection result. The re-training determination circuit 122 may determine whether the re-training of the non-volatile memory NVM is necessary, based on the error detection result. The re-training determination circuit 122 may determine whether the re-training conditions are satisfied, based on the error detection result.

According to some implementations, the re-training determination circuit 122 may count the number of data lines DQ from which errors are detected, as an error detection line number LNUM, based on the error detection result. For example, because the first through third sub-results SR1 through SR3 indicate the first value and the fourth sub-result SR4 indicates the second value, the re-training determination circuit 122 may count the error detection line number LNUM as '3'.

According to some implementations, the re-training determination circuit 122 may determine whether the re-training conditions are satisfied. The re-training determination circuit 122 may compare the error detection line number LNUM with a threshold value VTH determined in advance. The re-training determination circuit 122 may determine whether the error detection line number LNUM is equal to or greater than the threshold value VTH. The threshold value VTH is assumed to be '3'. However, embodiments are not limited thereto.

According to some implementations, the re-training determination circuit 122 may generate a determination result DR. The determination result DR may indicate whether re-training is necessary. In some implementations, the determination result DR may indicate whether the storage controller 110 is notified of occurrence of a transmission error. In some implementations, the determination result DR may indicate whether uncorrectable error correction code (UECC) has occurred. The UECC may indicate a state including an error that is not corrected by the ECC engine 115 of the storage controller 110.

For example, because the error detection line number LNUM (e.g., '3') is equal to or greater than the threshold value VTH (e.g., '3'), the re-training determination circuit 122 may determine that the re-training conditions are satisfied. The re-training determination circuit 122 may generate the determination result DR indicating a fourth value (e.g., 'YES'). For example, a third value (e.g., 'NO') may indicate that the re-training conditions are not satisfied. A fourth value (e.g., 'YES') may indicate that the re-training conditions are satisfied.

According to some implementations, when the re-training conditions are met, the first non-volatile memory NVM11 may not perform a program operation of storing data in the memory cell array 123. The first non-volatile memory NVM11 may notify the storage controller 110 that a transmission error has occurred, without storing data including an error in the memory cell array 123.

According to some implementations, when the re-training conditions are not met, the first non-volatile memory NVM11 may store data in the memory cell array 123. The first non-volatile memory NVM11 may perform a program operation in response to a write command. The first non-volatile memory NVM11 may transmit, to the storage controller 110, state information indicating a normal state.

In operation S150, the storage controller 110 may transmit a state read command to the first non-volatile memory NVM11. In operation S160, the first non-volatile memory NVM11 may transmit a response to the storage controller 110. The first non-volatile memory NVM11 may transmit the state information (or the response to the state read command) to the storage controller 110.

According to some implementations, the re-training determination circuit 122 may transmit the determination result DR to the control logic circuit 128. According to some implementations, the control logic circuit 128 may generate the response corresponding to the state read command, based on the determination result DR. For example, the response to the state read command may include a transmission error field. The transmission error field may indicate whether there is a transmission error of such a magnitude that re-training is necessary.

According to some implementations, the re-training determination circuit 122 may generate state information, based on the determination result DR. The non-volatile memory NVM may notify the storage controller 110 that re-training needs to be performed, through the state information. When it is determined that the re-training conditions are met, the non-volatile memory NVM may transmit state information indicating a transmission error state to the storage controller 110. When it is determined that the re-training conditions are not met, the non-volatile memory NVM may transmit state information indicating a normal state (or a no-error state) to the storage controller 110.

The storage controller 110 may perform re-training on the first non-volatile memory NVM11, in response to the state information indicating the transmission error state. The storage controller 110 may determine whether to perform re-training, based on the state information indicating the transmission error state.

According to some implementations, the storage controller 110 may perform re-training with respect to only the first non-volatile memory NVM11 from among the plurality of non-volatile memories NVM11 through NVMmn. However, embodiments are not limited thereto. According to some implementations, the storage controller 110 may perform re-training with respect to the non-volatile memories NVM12 through NVM1n sharing the first channel CH1 with the first non-volatile memory NVM11. In some implementations, the storage controller 110 may perform re-training with respect to all of the plurality of non-volatile memories NVM11 through NVMmn.

As described above, the storage controller 110 may generate a plurality of pieces of transmission parity data respectively corresponding to the plurality of data lines DQ. The storage controller 110 may transmit the write command, the data, and the plurality of pieces of transmission parity data to the first non-volatile memory NVM11 through the plurality of data lines DQ. The first non-volatile memory NVM11 may perform a transmission error detection operation with respect to each of the plurality of data lines DQ, based on each of the plurality of pieces of transmission parity data. The first non-volatile memory NVM11 may determine whether re-training execution conditions are satisfied, based on an error detection result generated in the transmission error detection operation. The storage controller 110 may transmit the state read command to the first non-volatile memory NVM11. In response to the state read command, when the re-training execution conditions are satisfied, the first non-volatile memory NVM11 may transmit the state information indicating the transmission error state to the storage controller 110. Accordingly, the performance and reliability of the storage device 100 may be improved.

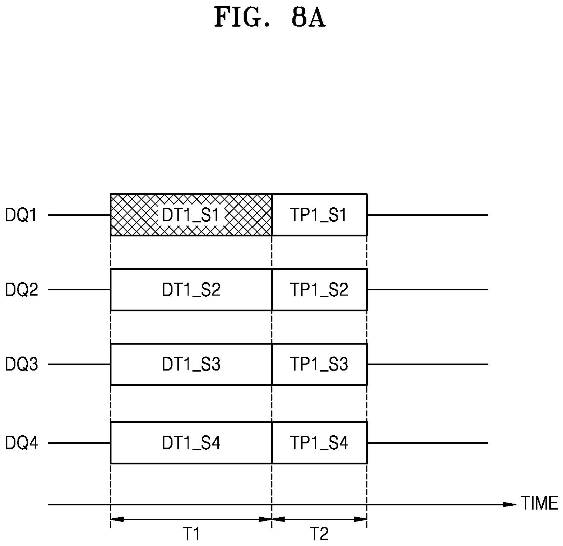

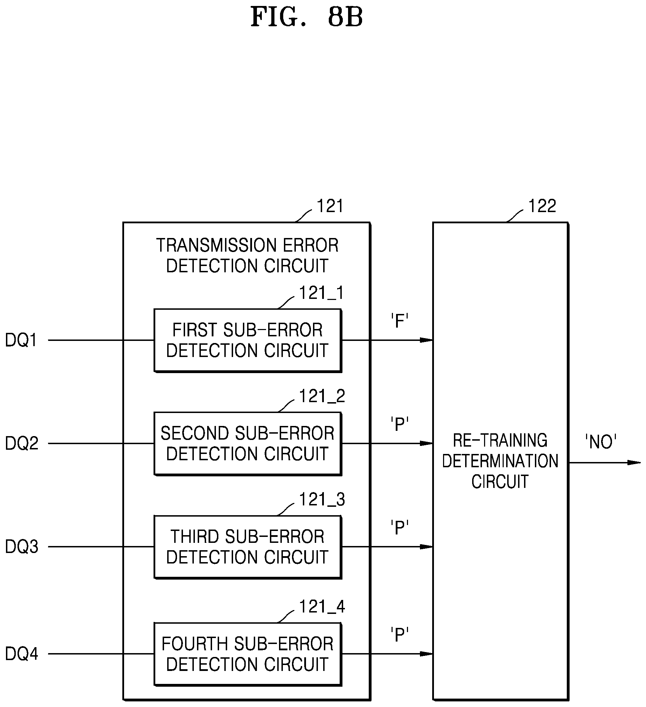

FIGS. 8A and 8B are drawings for explaining an example of a transmission error detection operation of the first non-volatile memory NVM11 of FIG. 2 according to some implementations. FIGS. 8A and 8B illustrate a case where the re-training conditions are not met. For convenience of explanation, detailed descriptions of the first through fourth sub-data DT1_S1 through DT1_S4 and the first through fourth sub-transmission parity data TP1_S1 through TP1_S4 described above are omitted.

In FIGS. 2, 7A, 7B, 8A, and 8B, the storage controller 110 may transmit the data DT1 and the transmission parity data TP1 to the first non-volatile memory NVM11. Additionally, the storage controller 110 may transmit memory parity data to the first non-volatile memory NVM11.

It is assumed that the first sub-data DT1_S1 includes a transmission error and the second through fourth sub-data DT1_S2 through DT1_S4 include no transmission errors. The first non-volatile memory NVM11 may receive the first sub-data DT1_S1 and the first sub-transmission parity data TP1_S1 through the first data line DQ1. The first non-volatile memory NVM11 may receive the second sub-data DT1_S2 and the second sub-transmission parity data TP1_S2 through the second data line DQ2. The first non-volatile memory NVM11 may receive the third sub-data DT1_S3 and the third sub-transmission parity data TP1_S3 through the third data line DQ3. The first non-volatile memory NVM11 may receive the fourth sub-data DT1_S4 and the fourth sub-transmission parity data TP1_S4 through the fourth data line DQ4.

Because the first sub-data DT1_S1 includes an error, the first sub-error detection circuit 121_1 may detect an error from the first sub-data DT1_S1, based on the first sub-transmission parity data TP1_S1. In other words, the first sub-error detection circuit 121_1 may determine that an error exists in the first sub-data DT1_S1. The first sub-error detection circuit 121_1 may generate the first sub-result SR1 indicating a first value (e.g., 'F').

Because the second sub-data DT1_S2 includes no errors, the second sub-error detection circuit 121_2 may determine that no errors exist in the second sub-data DT1_S2, based on the second sub-transmission parity data TP1_S2. The second sub-error detection circuit 121_2 may generate the second sub-result SR2 indicating the second value (e.g., 'P'). Because the third sub-data DT1_S3 includes no errors, the third sub-error detection circuit 121_3 may determine that no errors exist in the third sub-data DT1_S3, based on the third sub-transmission parity data TP1_S3. The third sub-error detection circuit 121_3 may generate the third sub-result SR3 indicating the second value (e.g., 'P'). Because the fourth sub-data DT1_S4 includes no errors, the fourth sub-error detection circuit 121_4 may determine that no errors exist in the fourth sub-data DT1_S4, based on the fourth sub-transmission parity data TP1_S4. The fourth sub-error detection circuit 121_4 may generate the fourth sub-result SR4 indicating the second value (e.g., 'P').

Because the first sub-result SR1 indicates the first value and the second through fourth sub-results SR2 through SR4 indicate the second value, the re-training determination circuit 122 may count the error detection line number LNUM as '1'. Because the error detection line number LNUM (e.g., '1') is less than the threshold value VTH (e.g., '3'), the re-training determination circuit 122 may determine that the re-training conditions are not satisfied. The re-training determination circuit 122 may generate the determination result DR indicating a third value (e.g., 'NO').

The first non-volatile memory NVM11 may generate state information indicating a normal state, based on the determination result DR indicating the third value. In response to a state read command, the first non-volatile memory NVM11 may transmit state information indicating a normal state to the storage controller 110.

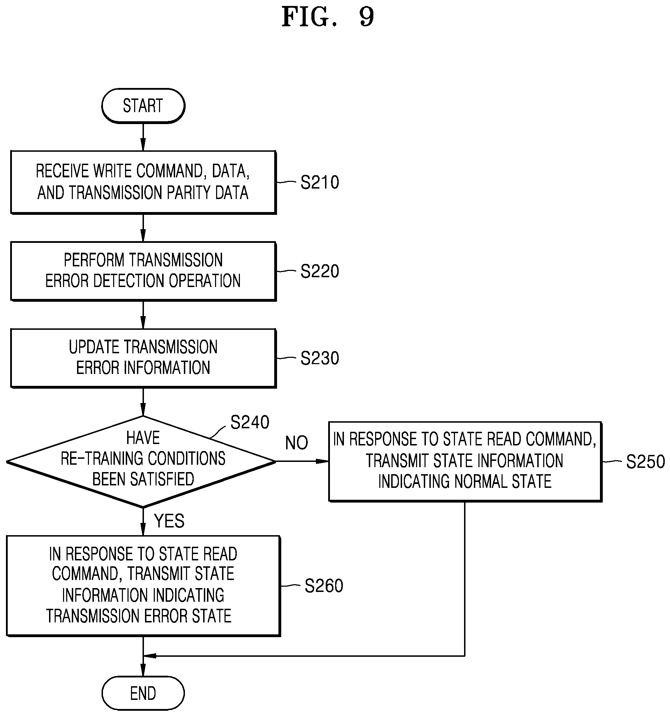

FIG. 9 is a flowchart of an example of an operation of the first non-volatile memory NVM11 of FIG. 2 according to some implementations. In FIGS. 2 and 9, in operation S210, the first non-volatile memory NVM11 may receive a write command, the data DT1, and the transmission parity data TP1. As described above, the transmission parity data TP1 may include a plurality of sub-transmission parity data TP1_S1 through TP1_S4, namely, first, second, third, and fourth sub-transmission parity data TP1_S1, TP1_S2, TP1_D3, and TP1_S4. The transmission parity data TP1 may be parity data used to detect a transmission error.

According to some implementations, the first non-volatile memory NVM11 may further receive memory parity data. In other words, the first non-volatile memory NVM11 may receive the write command, the data DT1, the memory parity data, and the transmission parity data TP1. The memory parity data may be parity data used to detect a memory cell error.

According to some implementations, the first non-volatile memory NVM11 may perform a decoding operation, based on the transmission parity data TP1. The first non-volatile memory NVM11 may detect an error of the data DT1, based on the transmission parity data TP1. The storage controller 110 may perform a decoding operation, based on the memory parity data. The storage controller 110 may detect an error from the data DT1, based on the memory parity data.

According to some implementations, the first non-volatile memory NVM11 may detect an error for each of the plurality of data lines DQ1 through DQ4. In other words, the first non-volatile memory NVM11 may detect an error of the first sub-data DT1_S1 corresponding to the first data line DQ1, based on the first sub-transmission parity data TP1_S1. The first non-volatile memory NVM11 may detect an error of the second sub-data DT1_S2 corresponding to the second data line DQ2, based on the second sub-transmission parity data TP1_S2. The storage controller 110 may detect an error of the data DT1, based on the memory parity data. The storage controller 110 may detect an error from the entire data DT1, other than an error for each of the plurality of data lines DQ1 through DQ4. The storage controller 110 may detect an error of the entire data DT1, based on the entire memory parity data.

In operation S220, the first non-volatile memory NVM11 may perform a transmission error detection operation. The first non-volatile memory NVM11 may detect a transmission error for each of the plurality of data lines DQ1 through DQ4. The first non-volatile memory NVM11 may generate an error detection result.

In operation S230, the first non-volatile memory NVM11 may update transmission error information. The first non-volatile memory NVM11 may update transmission error information, based on the error detection result. The first non-volatile memory NVM11 may store the transmission error information in a memory circuit included in the first non-volatile memory NVM11. For example, the memory circuit may include a plurality of latch circuits.

According to some implementations, the transmission error information may include a history of the error detection result. The first non-volatile memory NVM11 may accumulate error detection results and transmit the accumulated error detection results as the transmission error information. For example, the transmission error information may include at least one of identifier information of data lines from which transmission errors have been detected, the number of errors detected in data, or the time at which an error is detected. The transmission error information may include information necessary for analyzing a transmission error. The transmission error information may additionally include a temperature when a transmission error is detected, a reference voltage when a transmission error is detected, and an oscillator value when a transmission error is detected.

In operation S240, the first non-volatile memory NVM11 may determine whether the re-training conditions have been satisfied. The re-training conditions may be previously determined. According to some implementations, the re-training conditions may include whether UECC is likely to occur. By adjusting the re-training conditions, a channel bit error rate (BER) tolerance range may be determined. The storage device 100 may optimize input/output power by determining a channel BER.

According to some implementations, the first non-volatile memory NVM11 may determine the number of data lines from which errors have been detected. When the number of data lines from which errors have been detected is greater than or equal to a threshold value, the first non-volatile memory NVM11 may determine whether the re-training conditions have been satisfied. When the number of data lines from which errors have been detected is less than the threshold value, the first non-volatile memory NVM11 may determine whether the re-training conditions have not been satisfied. The first non-volatile memory NVM11 may perform operation S260 when the re-training conditions have been satisfied, and may perform operation S250 when the re-training conditions have not been satisfied.

In operation S250, in response to a state read command, the first non-volatile memory NVM11 may transmit state information indicating a normal state to the storage controller 110. The first non-volatile memory NVM11 may store the received data in the memory cell array 123.

According to some implementations, the first non-volatile memory NVM11 may store both the data and the transmission parity data in the memory cell array 123. According to some implementations, the first non-volatile memory NVM11 may store only the data in the memory cell array 123, and may not store the transmission parity data TP1 in the memory cell array 123. Because the first non-volatile memory NVM11 does not store the transmission parity data, the first non-volatile memory NVM11 may more efficiently use a storage space. Because the first non-volatile memory NVM11 has used the transmission parity data in a transmission error detection operation, the first non-volatile memory NVM11 may not store the transmission parity data.

According to some implementations, when the first non-volatile memory NVM11 receives the data, the memory parity data, and the transmission parity data in operation S210, the first non-volatile memory NVM11 may store all of the data, the memory parity data, and the transmission parity data in the memory cell array 123. In this case, because the transmission parity data is additionally stored in the memory cell array 123, the size of the memory parity data may be less than when the transmission parity data is not stored.

According to some implementations, the first non-volatile memory NVM11 may store only the data and the memory parity data in the memory cell array 123, and may not store the transmission parity data in the memory cell array 123. The first non-volatile memory NVM11 may store the memory parity data in the memory cell array 123, and then, in response to a read command, may transmit both of the data DT1 and the memory parity data to the storage controller 110. The memory parity data is used to address memory cell reliability issues. Accordingly, in order for the storage controller 110 to detect an error in read data, the first non-volatile memory NVM11 may store the memory parity data in the memory cell array 123 and then transmit the memory parity data to the storage controller 110 together with the read data.

After programming the data in the memory cell array 123, the first non-volatile memory NVM11 may transmit the state information indicating a normal state to the storage controller 110. According to some implementations, when the first non-volatile memory NVM11 has failed in programming, the first non-volatile memory NVM11 may transmit the state information indicating a programming failure state to the storage controller 110.

In operation S260, in response to a state read command, the first non-volatile memory NVM11 may transmit the state information indicating a transmission error state to the storage controller 110. When the re-training conditions have been satisfied, the first non-volatile memory NVM11 may not perform a program operation. The first non-volatile memory NVM11 may not store data including an error, in the memory cell array 123. The first non-volatile memory NVM11 may receive the state read command. In response to the state read command, the first non-volatile memory NVM11 may transmit the state information indicating a transmission error state to the storage controller 110. For example, the first non-volatile memory NVM11 may output the state information indicating a transmission error state, through the plurality of data lines DQ.

Accordingly, the first non-volatile memory NVM11 may notify the storage controller 110 that a transmission error has occurred. The first non-volatile memory NVM11 may actively notify the storage controller 110 that re-training is to be performed. Accordingly, the storage device 100 may not perform monitoring of the plurality of non-volatile memories NVM11 through NVMnm of the storage controller 110. The storage device 100 may perform re-training triggered by each of the plurality of non-volatile memories NVM11 through NVM1n. The storage device 100 may selectively perform re-training with respect to the first non-volatile memory NVM11 which requires re-training. Accordingly, a storage device with improved performance and reliability is provided.

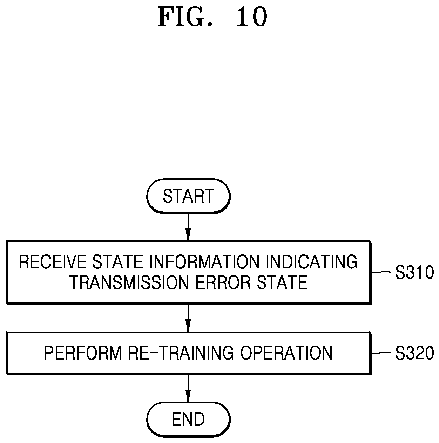

FIG. 10 is a flowchart of an example of operation of the storage controller 110 of FIG. 1 according to some implementations. In FIGS. 1 and 10, the storage controller 110 may perform re-training with respect to at least one of the plurality of non-volatile memories NVM11 through NVMmn.

In operation S310, the storage controller 110 may receive the state information indicating a transmission error state from the first non-volatile memory NVM11. The storage controller 110 may not transmit a separate command in order to determine a re-training time of the first non-volatile memory NVM11. The storage controller 110 may determine the re-training time of the first non-volatile memory NVM11, through a writing operation of the first non-volatile memory NVM11, which is a normal operation.

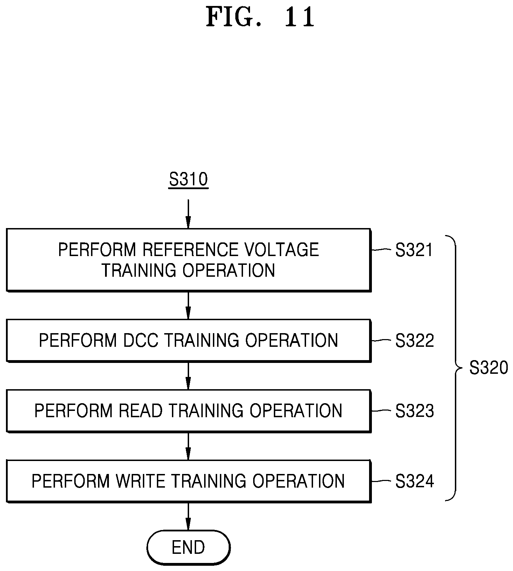

In operation S320, the storage controller 110 may perform a re-training operation with respect to the first non-volatile memory NVM11. The re-training operation may include at least one of a reference voltage training operation, a duty cycle correction (DCC) training operation, a read training operation, or a write training operation. The re-training operation will be described in detail with reference to FIG. 11.

As described above, the storage controller 110 may determine the re-training time of the first non-volatile memory NVM11, through a general write operation, without a monitoring operation. The storage controller 110 may determine whether re-training is performed, based on the state information indicating a transmission error state. The storage controller 110 may perform re-training in response to the state information indicating a transmission error state. The storage controller 110 may perform at least one of a reference voltage training operation, a double data rate training operation, a read training operation, or a write training operation with respect to the first non-volatile memory NVM11.

FIG. 11 is a flowchart showing an example of operation S320 of FIG. 10 according to some implementations. In FIGS. 2, 10, and 11, the storage controller 110 may perform a re-training operation. Operation S320 may include at least one of operations S321 through S324. According to an embodiment, because the re-training may be performed on each of a plurality of pins, the re-training may be per-pin training. The storage controller 110 may perform a re-training operation with respect to at least one of the plurality of data lines DQ of the first non-volatile memory NVM11. The storage controller 110 may perform a re-training operation with respect to only a data line from which a transmission error has been detected.

In operation S321, the storage controller 110 may perform a reference voltage training operation with respect to the first non-volatile memory NVM11. In operation S322, the storage controller 110 may perform a DCC training operation with respect to the first non-volatile memory NVM11.

In a DDR mode, each of the signals of the plurality of data lines DQ may be sequentially sampled in synchronization with a rising edge and a falling edge of the signal of the data strobe line DQS. Each of the signals of the plurality of data lines DQ may be divided into a logic high section and a logic low section, based on a reference voltage level. For example, in each of the signals of the plurality of data lines DQ, a section higher than the reference voltage level may be distinguished as a logic high section, and a section lower than the reference voltage level may be distinguished as a logic low section. Data windows of the signals of first and second data lines may be determined according to a ratio of a logic high section and a logic low section of first and second data sampled according to the signal of the data strobe line DQS, based on the reference voltage level.

When a "duty mismatch" occurs in each of the signals of the plurality of data lines DQ, the logic high section and the logic low section of each of the signals of the plurality of data lines DQ may have different lengths. In other words, a ratio between the logic high section and the logic low section may not be 1:1. At this time, the signals of the first and second data lines may have data windows of different lengths, and valid data windows of the signals of the first and second data lines may decrease, resulting in some embodiments in a degradation in the performance of the storage device 100. Accordingly, a method of securing a valid data window by performing duty correction based on a reference voltage level is needed to address the duty mismatch of each of the signals of the plurality of data lines DQ. The storage device 100 may perform a reference voltage training operation of determining a reference voltage level for addressing a duty mismatch.

According to some implementations, the storage device 100 may perform a DCC training operation to address the duty mismatch of each of the signals of the plurality of data lines DQ. The storage device 100 may adjust the ratio between the logic high section and the logic low section to a desired ratio (e.g., 1:1), by using DCC training.

In operation S323, the storage controller 110 may perform a read training operation with respect to the first non-volatile memory NVM11. In operation S324, the storage controller 110 may perform a write training operation with respect to the first non-volatile memory NVM11.

Even when respective phases of the signals are aligned at the time of transmission, skew where a difference is generated between time points at which a plurality of signals reach a receiver may occur due to noise during a communication process. In order for a device receiving a signal to sample the signal of the data line DQ to generate accurate data DATA, an optimal delay needs to be applied to the signal of the data strobe line DQS. A delay needed by the signal of the data strobe line DQS to accurately sample each of the signals of the plurality of data lines DQ is referred to as a target delay. When the delay applied to the signal of the data strobe line DQS is not the target delay or data skew is not addressed, the possibility of occurrence of communication errors in the storage device 100 may increase. The storage device 100 may perform a training operation for determining an alignment of the signals of the plurality of data lines DQ between the storage controller 110 and each of the plurality of non-volatile memories NVM11 through NVMnm and a target delay of the signal of the data strobe line DQS. The storage device 100 may perform training (e.g., read training or write training) to increase the accuracy of communication when performing all functions.

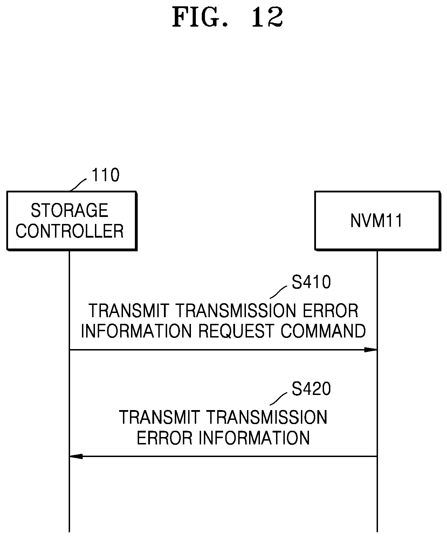

FIG. 12 is a flowchart of an example of operation of the storage device 100 of FIG. 2 according to some implementations. In FIGS. 2 and 12, the storage device 100 may detect a transmission error by performing a transmission error detection operation. The storage device 100 may generate transmission error information, based on a result of the transmission error detection. The storage device 100 may store the transmission error information.

In operation S410, the storage controller 110 may transmit a transmission error information request command to the first non-volatile memory NVM11. According to some implementations, the transmission error information request command may be a Get Feature command or a Vendor Command. However, embodiments are not limited thereto.

In operation S420, the first non-volatile memory NVM11 may transmit the transmission error information to the storage controller 110. The first non-volatile memory NVM11 may receive the transmission error information request command. In response to the transmission error information request command, the first non-volatile memory NVM11 may transmit the stored transmission error information to the storage controller 110. For example, the first non-volatile memory NVM11 may output the transmission error information through the plurality of data lines DQ.

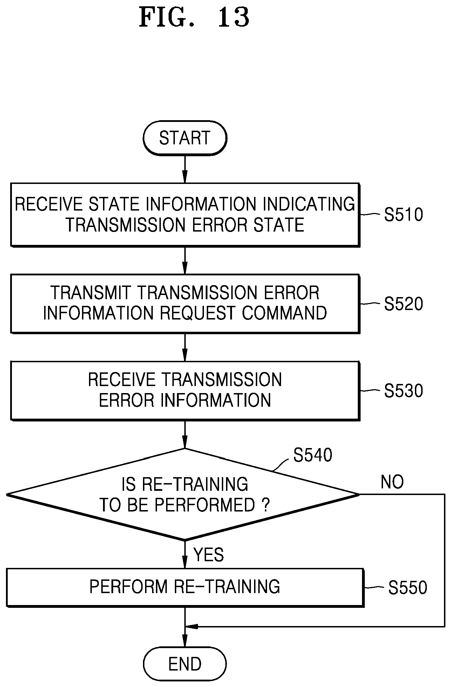

FIG. 13 is a flowchart of an example of operation of the storage controller 110 of FIG. 2 according to some implementations. In FIGS. 2 and 13, the storage controller 110 may perform re-training, based on the state information indicating a transmission error state and the transmission error information.

In operation S510, the storage controller 110 may receive the state information indicating a transmission error state from the first non-volatile memory NVM11. In operation S520, the storage controller 110 may transmit the transmission error information request command to the first non-volatile memory NVM11. The storage controller 110 may transmit the transmission error information request command to the first non-volatile memory NVM11, instead of immediately performing re-training on the first non-volatile memory NVM11, in response to the state information indicating the transmission error state. The storage controller 110 may request the first non-volatile memory NVM11 for more information, in order to determine whether to perform re-training. Accordingly, the storage controller 110 may transmit the transmission error information request command to the first non-volatile memory NVM11. In operation S530, the storage controller 110 may receive the transmission error information from the first non-volatile memory NVM11.

In operation S540, the storage controller 110 may determine whether to perform re-training. According to some implementations, the storage controller 110 may determine whether to perform re-training, based on the transmission error information. The storage controller 110 may perform operation S550 when it is determined that re-training is to be performed, and may not perform operation S550 when it is determined that re-training is not to be performed. According to an embodiment, the storage controller 110 may determine the type of training or the range of training, based on the transmission error information.

According to some implementations, the storage controller 110 may determine what training operation is to be performed among re-training operations, based on the transmission error information. In other words, the storage controller 110 may determine the type of training, based on the transmission error information. For example, the storage controller 110 may determine to perform_at least one of a reference voltage training operation, a DCC training operation, a read training operation, or a write training operation. The storage controller 110 may determine to perform only a write operation with respect to the first non-volatile memory NVM11.

According to some implementations, the storage controller 110 may perform a training operation with respect to all of the plurality of data lines DQ. In some implementations, the storage controller 110 may determine a data line that is to undergo a training operation from among all of the plurality of data lines DQ. In other words, the storage controller 110 may determine the range of training, based on the transmission error information. The storage controller 110 may select at least one of the plurality of data lines DQ.

For example, the storage controller 110 may recognize that a transmission error has been detected from the first through third data lines DQ1 through DQ3, through the transmission error information. For example, the storage controller 110 may recognize that no transmission errors have been detected from the fourth data lines DQ4, through the transmission error information. Accordingly, the storage controller 110 may determine to perform training with respect to the first through third data lines DQ1 through DQ3 of the first non-volatile memory NVM11. The storage controller 110 may determine not to perform training with respect to the fourth data lines DQ4 of the first non-volatile memory NVM11.

In operation S550, the storage controller 110 may perform a re-training operation with respect to the first non-volatile memory NVM11. The storage controller 110 may perform re-training, based on the determined type of training or the determined range of training. For example, the storage controller 110 may perform write training with respect to the first through third data lines DQ1 through DQ3 of the first non-volatile memory NVM11. The storage controller 110 may not perform training with respect to the fourth data lines DQ4 of the first non-volatile memory NVM11.

According to some implementations, the storage controller 110 may perform a normal operation on the second non-volatile memory NVM21, while performing re-training on the first non-volatile memory NVM11. The second non-volatile memory NVM21 may not share a channel with the first non-volatile memory NVM11. A channel with the first non-volatile memory NVM11 and a channel of the second non-volatile memory NVM21 may be different from each other. The storage controller 110 may perform a read operation or a write operation on the second non-volatile memory NVM21 while performing a re-training operation on the first non-volatile memory NVM11.

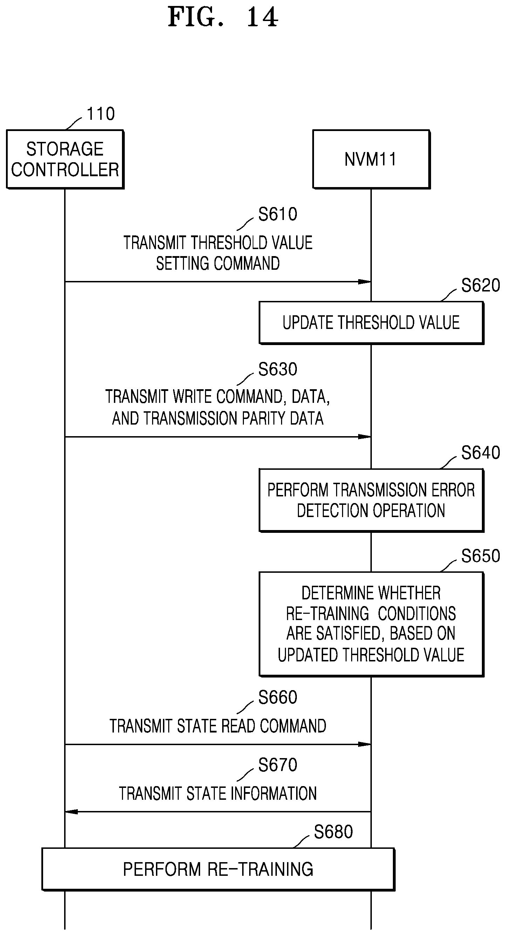

FIG. 14 is a flowchart of an example of an operation of the storage device 100 of FIG. 2 according to some implementations. In FIGS. 2 and 14, the storage device 100 may change a threshold value while operating. The storage device 100 may adjust the threshold value, based on a current state of the non-volatile memory device 120.

In operation S610, the storage controller 110 may transmit a threshold value setting command to the first non-volatile memory NVM11. According to some implementations, the threshold value setting command may be a Set Feature command or a Vendor Command. However, embodiments are not limited thereto. According to some implementations, the threshold value setting command may include information about the threshold value to be changed.

In operation S620, the first non-volatile memory NVM11 may update the threshold value. The first non-volatile memory NVM11 may receive the threshold value setting command. The first non-volatile memory NVM11 may update the threshold value in response to the threshold value setting command. For example, the first non-volatile memory NVM11 may store the threshold value in a register included in the first non-volatile memory NVM11. The first non-volatile memory NVM11 may store the threshold value included in the threshold value setting command, in the register. The first non-volatile memory NVM11 may update the changed threshold value. For example, the first non-volatile memory NVM11 may adjust the threshold value to '2'.

In operation S630, the storage controller 110 may transmit the write command, the data, and the transmission parity data to the first non-volatile memory NVM11. In operation S640, the first non-volatile memory NVM11 may perform a transmission error detection operation. In operation S650, the first non-volatile memory NVM11 may determine whether the re-training conditions have been satisfied, based on the updated threshold value. The first non-volatile memory NVM11 may count the number of data lines from which errors have been detected. The first non-volatile memory NVM11 may compare the error detection line number LNUM with the threshold value. For example, the first non-volatile memory NVM11 may compare the error detection line number LNUM with the changed threshold value (e.g., '2').

In operation S660, the storage controller 110 may transmit the state read command to the first non-volatile memory NVM11. In operation S670, in response to the state read command, the first non-volatile memory NVM11 may transmit the state information to the storage controller 110. When the error detection line number LNUM is equal to or greater than the changed threshold value, the first non-volatile memory NVM11 may transmit the state information indicating the transmission error state to the storage controller 110. When the error detection line number LNUM is less than the changed threshold value, the first non-volatile memory NVM11 may transmit the state information indicating the normal state to the storage controller 110.

In operation S680, the storage controller 110 may perform re-training. The storage controller 110 may perform re-training on the first non-volatile memory NVM11, in response to the state information indicating the transmission error state. Alternatively, the storage device 110 may obtain transmission error information, through the transmission error information request command. The storage controller 110 may perform re-training, based on the transmission error information.

The storage controller 110 may not perform the operation of operation S680 in response to the state information indicating a normal state. In other words, the storage controller 110 may not perform re-training in response to the state information indicating a normal state.

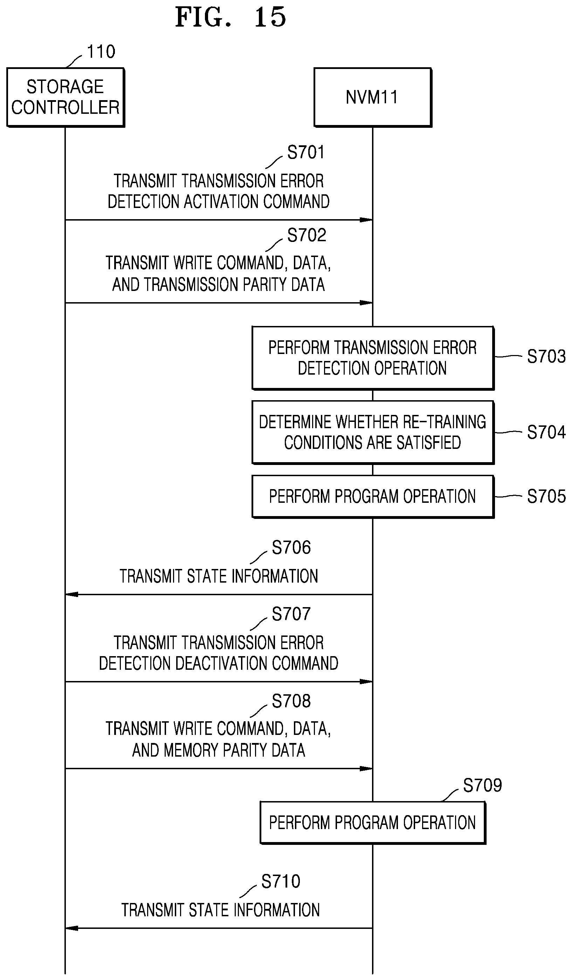

FIG. 15 is a flowchart of an example of an operation of the storage device 100 of FIG. 2 according to some implementations. In FIGS. 2 and 15, the storage device 100 may activate or deactivate a transmission error detection operation. The storage controller 110 may transmit a transmission error detection activation command. The first non-volatile memory NVM11 may perform a transmission error detection operation in response to a subsequently-received write command, based on the transmission error detection activation command. The storage controller 110 may transmit a transmission error detection deactivation command. The first non-volatile memory NVM11 may not perform a transmission error detection operation in response to a subsequently-received write command, based on the transmission error detection deactivation command.

In operation S701, the storage controller 110 may transmit a transmission error detection activation command. The transmission error detection activation command may refer to a command for activating a transmission error detection operation within the first non-volatile memory NVM11. The first non-volatile memory NVM11 may receive the transmission error detection activation command. The first non-volatile memory NVM11 may activate a transmission error detection flag in response to the transmission error detection activation command. The transmission error detection flag may be stored in the register included in the first non-volatile memory NVM11.

In operation S702, the storage controller 110 may transmit the write command, the data, and the transmission parity data to the first non-volatile memory NVM11. The storage device 110 may generate he transmission parity data, based on the data. The storage controller 110 may further transmit the memory parity data.

In operation S703, the first non-volatile memory NVM11 may perform a transmission error detection operation. The first non-volatile memory NVM11 may perform a transmission error detection operation in response to the activated transmission error detection flag. The first non-volatile memory NVM11 may detect an error for each of the plurality of data lines DQ.

In operation S704, the first non-volatile memory NVM11 may determine whether the re-training conditions are satisfied, based on a result of the error detection. For example, the first non-volatile memory NVM1 1 may count the number of data lines from which errors have been detected. The first non-volatile memory NVM11 may compare the number of data lines from which errors have been detected with a threshold value. The first non-volatile memory NVM11 may determine whether the number of data lines from which errors have been detected is equal to or greater than the threshold value.

In operation S705, the first non-volatile memory NVM11 may perform a program operation. When the re-training conditions have not been satisfied, the first non-volatile memory NVM11 may perform a program operation. The first non-volatile memory NVM11 may store the data in a memory cell array. When the re-training conditions have been satisfied, the first non-volatile memory NVM11 may not perform the operation of operation S705.

In operation S706, the first non-volatile memory NVM11 may transmit the state information to the storage controller 110. When the re-training conditions have been satisfied, the first non-volatile memory NVM11 may transmit the state information indicating a transmission error state to the storage controller 110, in response to the state read command. When the re-training conditions have not been satisfied, the first non-volatile memory NVM11 may transmit the state information indicating a normal state to the storage controller 110, in response to the state read command. In response to the state information indicating a transmission error state, the storage controller 110 may perform re-training with respect to the first non-volatile memory NVM11.

In operation S707, the storage controller 110 may transmit the transmission error detection deactivation command to the first non-volatile memory NVM11. The transmission error detection deactivation command may refer to a command for deactivating a transmission error detection operation within the first non-volatile memory NVM11. The first non-volatile memory NVM11 may receive the transmission error detection deactivation command. The first non-volatile memory NVM11 may deactivate a transmission error detection flag in response to the transmission error detection deactivation command.

In operation S708, the storage controller 110 may transmit the write command and the data to the first non-volatile memory NVM11. The storage controller 110 may further transmit the memory parity data. The storage device 110 may not generate the transmission parity data, based on the data. The storage controller 110 may not transmit the transmission parity data to the first non-volatile memory NVM11.

The first non-volatile memory NVM11 may not perform the transmission error detection operation. The first non-volatile memory NVM11 may not perform a transmission error detection operation in response to the deactivated transmission error detection flag.

In operation S709, the first non-volatile memory NVM11 may perform a program operation. The first non-volatile memory NVM11 may store the data in the memory cell array. According to an embodiment, the first non-volatile memory NVM11 may store the memory parity data in the memory cell array.

In operation S710, the first non-volatile memory NVM11 may transmit the state information to the storage controller 110. In response to a state read command, the first non-volatile memory NVM11 may transmit state information indicating a normal state to the storage controller 110.

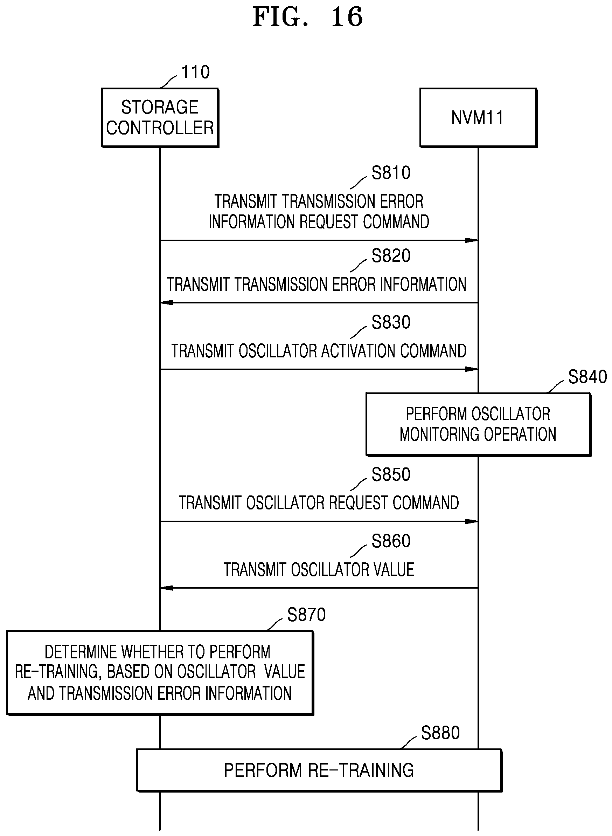

FIG. 16 is a flowchart of an example of an operation of the storage device 100 of FIG. 2 according to some implementations. In FIGS. 2 and 15, the storage device 100 may determine a re-training time, based on at least one of transmission error information, an oscillator value of a data strobe signal, temperature information, or voltage information.

According to some implementations, the storage controller 110 may monitor a temperature and a voltage for each of the plurality of non-volatile memories NVM. The storage controller 110 may receive temperature information or voltage information for the plurality of non-volatile memories NVM. The storage controller 110 may periodically request for the temperature information or the voltage information for each of the plurality of non-volatile memories NVM. The storage controller 110 may determine whether to perform re-training for each of the plurality of non-volatile memories NVM, based on the temperature information or the voltage information.

In operation S810, the storage controller 110 may transmit the transmission error information request command to the first non-volatile memory NVM11. For example, the storage controller 110 may transmit the transmission error information request command to the first non-volatile memory NVM11, in response to the state information indicating a transmission error state. In operation S820, the first non-volatile memory NVM11 may transmit the transmission error information to the storage controller 110. In response to the transmission error information request command, the first non-volatile memory NVM11 may transmit the stored transmission error information to the storage controller 110.

In operation S830, the storage controller 110 may transmit an oscillator activation command to the first non-volatile memory NVM11. In operation S840, the first non-volatile memory NVM11 may perform an oscillator monitoring operation. For example, the first non-volatile memory NVM11 may perform an oscillator monitoring operation in response to the oscillator activation command. That is, the first non-volatile memory NVM11 may monitor an oscillator value of the data strobe signal. For example, the oscillator value may indicate an oscillator count value. The oscillator monitoring operation may refer to an operation of counting the number of oscillations of the signal (or the data strobe signal) of the data strobe line DQS. The first non-volatile memory NVM11 may count the number of oscillations of the signal (or the data strobe signal) of the data strobe line DQS.

In operation S850, the storage controller 110 may transmit an oscillator request command to the first non-volatile memory NVM11. For example, the storage controller 110 may request for the oscillator count value. In operation S860, the first non-volatile memory NVM11 may transmit the oscillator value to the storage controller 110. For example, the first non-volatile memory NVM11 may transmit an oscillator count value for the data strobe signal in response to the oscillator request command.

In operation S870, the storage controller 110 may determine whether to perform re-training, based on the oscillator value and the transmission error information. However, embodiments are not limited thereto, and the storage controller 110 may determine whether to perform re-training, based on at least one of the transmission error information, the oscillator value of the data strobe signal, the temperature information, or the voltage information.

In operation S880, the storage controller 110 may perform re-training with respect to the first non-volatile memory NVM11. The storage controller 110 may determine that re-training is needed, based on the oscillator value and the transmission error information. In this case, the storage controller 110 may perform a re-training operation with respect to the first non-volatile memory NVM11.

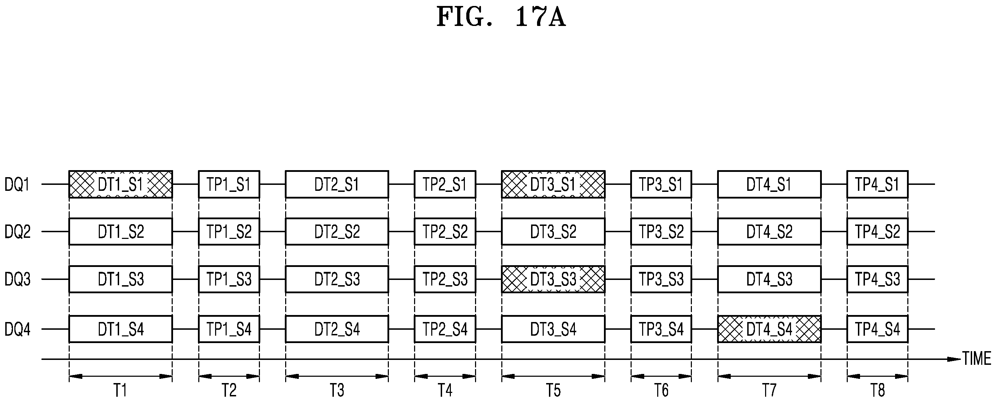

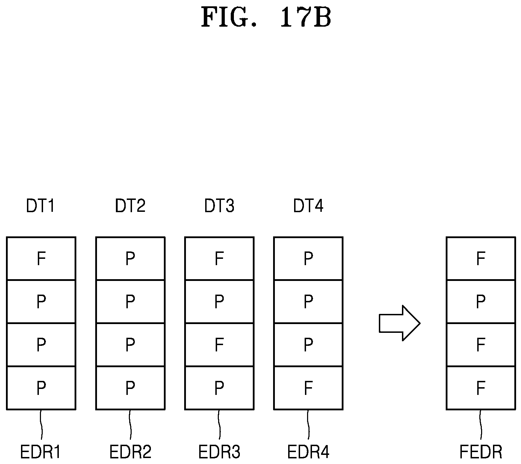

FIGS. 17A and 17B are drawings for explaining an example of a transmission error detection operation of the first non-volatile memory NVM11 of FIG. 2 according to some implementations. In FIGS. 2, 17A, and 17B, the first non-volatile memory NVM11 may determine whether the re-training conditions have been satisfied, based on the accumulated error detection results. For example, the first non-volatile memory NVM11 may receive the first data DT1 during a first period T1, and may receive the first transmission parity data TP1 during a second period T2. The first transmission parity data TP1 may correspond to the first data DT1. The first transmission parity data TP1 may be transmission parity data for the first data DT1.

The first non-volatile memory NVM11 may receive the second data DT2 during a third period T3, and may receive the second transmission parity data TP2 during a fourth period T4. The second transmission parity data TP2 may correspond to the second data DT2. The first non-volatile memory NVM11 may receive the third data DT3 during a fifth period T5, and may receive the third transmission parity data TP3 during a sixth period T6. The third transmission parity data TP3 may correspond to the third data DT3. The first non-volatile memory NVM11 may receive the fourth data DT4 during a seventh period T7, and may receive the fourth transmission parity data TP4 during an eighth period T8. The fourth transmission parity data TP4 may correspond to the fourth data DT4.

For example, the first data DT1 may include first, second, third, and fourth sub-data DT1_S1, DT1_S2, DT1_S3, and DT1_S4, and the first transmission parity data TP1 may include first, second, third, and fourth sub-transmission parity data TP1_S1, TP1_S2, TP1_S3, and TP1_S4. The first sub-transmission parity data TP1_S1 may correspond to the first sub-data DT1_S1, the second sub-transmission parity data TP1_S2 may correspond to the second sub-data DT1_S2, the third sub-transmission parity data TP1_S3 may correspond to the third sub-data DT1_S3, and the fourth sub-transmission parity data TP1_S4 may correspond to the fourth sub-data DT1_S4.

The second data DT2 may include first, second, third, and fourth sub-data DT2_S1, DT2_S2, DT2_S3, and DT2_S4, and the second transmission parity data TP2 may include first, second, third, and fourth sub-transmission parity data TP2_S1, TP2_S2, TP2_S3, and TP2_S4. The first sub-transmission parity data TP2_S1 may correspond to the first sub-data DT2_S1, the second sub-transmission parity data TP2_S2 may correspond to the second sub-data DT2_S2, the third sub-transmission parity data TP2_S3 may correspond to the third sub-data DT2_S3, and the fourth sub-transmission parity data TP2_S4 may correspond to the fourth sub-data DT2_S4.

The third data DT3 may include first, second, third, and fourth sub-data DT3_S1, DT3_S2, DT3 _S3, and DT3_S4, and the third transmission parity data TP3 may include first, second, third, and fourth sub-transmission parity data TP3_S1, TP3_S2, TP3_S3, and TP3_S4. The first sub-transmission parity data TP3_S1 may correspond to the first sub-data DT3_S1, the second sub-transmission parity data TP3_S2 may correspond to the second sub-data DT3_S2, the third sub-transmission parity data TP3_S3 may correspond to the third sub-data DT3_S3, and the fourth sub-transmission parity data TP3_S4 may correspond to the fourth sub-data DT3_S4.

The fourth data DT4 may include first, second, third, and fourth sub-data DT4_S1, DT4_S2, DT4_S3, and DT4_S4, and the fourth transmission parity data TP4 may include first, second, third, and fourth sub-transmission parity data TP4_S1, TP4_S2, TP4_S3, and TP4_S4. The first sub-transmission parity data TP4_S1 may correspond to the first sub-data DT4_S1, the second sub-transmission parity data TP4_S2 may correspond to the second sub-data DT4_S2, the third sub-transmission parity data TP4_S3 may correspond to the third sub-data DT4_S3, and the fourth sub-transmission parity data TP4_S4 may correspond to the fourth sub-data DT4_S4.

The first non-volatile memory NVM11 may receive the first sub-data DT1_S1, the first sub-transmission parity data TP1_S1, the first sub-data DT2_S1, the first sub-transmission parity data TP2_S1, the first sub-data DT3_S1, the first sub-transmission parity data TP3_S1, the first sub-data DT4_S1, and the first sub-transmission parity data TP4_S1, through the first data line DQ1. The first non-volatile memory NVM11 may receive the second sub-data DT1_S2, the second sub-transmission parity data TP1_S2, the second sub-data DT2_S2, the second sub-transmission parity data TP2_S2, the second sub-data DT3_S2, the second sub-transmission parity data TP3_S2, the second sub-data DT4_S2, and the second sub-transmission parity data TP4_S2, through the second data line DQ2. The first non-volatile memory NVM11 may receive the third sub-data DT1_S3, the third sub-transmission parity data TP1_S3, the third sub-data DT2_S3, the third sub-transmission parity data TP2_S3, the third sub-data DT3_S3, the third sub-transmission parity data TP3_S3, the third sub-data DT4_S3, and the third sub-transmission parity data TP4_S3, through the third data line DQ3. The first non-volatile memory NVM11 may receive the fourth sub-data DT1_S4, the fourth sub-transmission parity data TP1_S4, the fourth sub-data DT2_S4, the fourth sub-transmission parity data TP2_S4, the fourth sub-data DT3_S4, the fourth sub-transmission parity data TP3_S4, the fourth sub-data DT4_S4, and the fourth sub-transmission parity data TP4_S4, through the fourth data line DQ4.

The transmission error detection circuit 121 may perform a transmission error detection operation with respect to the first sub-data DT1_S1, based on the first sub-transmission parity data TP1_S1, may perform a transmission error detection operation with respect to the second sub-data DT1_S2, based on the second sub-transmission parity data TP1_S2, may perform a transmission error detection operation with respect to the third sub-data DT1_S3, based on the third sub-transmission parity data TP1_S3, and may perform a transmission error detection operation with respect to the fourth sub-data DT1_S4, based on the fourth sub-transmission parity data TP1_S4.

The transmission error detection circuit 121 may perform a transmission error detection operation with respect to the first sub-data DT2_S1, based on the first sub-transmission parity data TP2_S1, may perform a transmission error detection operation with respect to the second sub-data DT2_S2, based on the second sub-transmission parity data TP2_S2, may perform a transmission error detection operation with respect to the third sub-data DT2_S3, based on the third sub-transmission parity data TP2_S3, and may perform a transmission error detection operation with respect to the fourth sub-data DT2_S4, based on the fourth sub-transmission parity data TP2_S4. Because the remaining sub-data DT3_S1 through DT3_S4 and DT4_S1 through DT4_S4 are similar to the sub-data DT1_S1 through DT1_S4 and DT2_S1 through DT2_S4, detailed descriptions thereof are omitted.

It is assumed that the first sub-data DT1_S1, the first sub-data DT3_D1, the third sub-data DT3_S3, and the fourth sub-data DT4_S4 include transmission errors. The first non-volatile memory NVM11 may generate a first error detection result, based on the first data DT1 and the first transmission parity data TP1. For example, because the first sub-data DT1_S1 includes an error, a first sub-result of a first error detection result EDR1 may indicate a first value 'F'. Because the second sub-data DT1_S2 includes no errors, a second sub-result of the first error detection result EDR1 may indicate a second value 'P'. Because the third sub-data DT1_S3 includes no errors, a third sub-result of the first error detection result EDR1 may indicate the second value 'P'. Because the fourth sub-data DT1_S4 includes no errors, a fourth sub-result of the first error detection result EDR1 may indicate the second value 'P'.

For example, because the first sub-data DT2_S1 includes no errors, a first sub-result of a second error detection result EDR2 may indicate the second value 'P'. Because the second sub-data DT2_S2 includes no errors, a second sub-result of the second error detection result EDR2 may indicate the second value 'P'. Because the third sub-data DT2_S3 includes no errors, a third sub-result of the second error detection result EDR2 may indicate the second value 'P'. Because the fourth sub-data DT1_S4 includes no errors, a fourth sub-result of the second error detection result EDR2 may indicate the second value 'P'.

For example, because the first sub-data DT3_S1 includes an error, a first sub-result of a third error detection result EDR3 may indicate the first value 'F'. Because the second sub-data DT3_S2 includes no errors, a second sub-result of the third error detection result EDR3 may indicate the second value 'P'. Because the third sub-data DT3_S3 includes an error, a third sub-result of the third error detection result EDR3 may indicate the first value 'F'. Because the fourth sub-data DT3_S4 includes no errors, a fourth sub-result of the third error detection result EDR3 may indicate the second value 'P'.

For example, because the first sub-data DT4_S1 includes no errors, a first sub-result of a fourth error detection result EDR4 may indicate the second value 'P'. Because the second sub-data DT4_S2 includes no errors, a second sub-result of the fourth error detection result EDR4 may indicate the second value 'P'. Because the third sub-data DT4_S3 includes no errors, a third sub-result of the fourth error detection result EDR4 may indicate the second value 'P'. Because the fourth sub-data DT4_S3 includes an error, a fourth sub-result of the fourth error detection result EDR4 may indicate the first value 'F'.

The first non-volatile memory NVM11 may determine whether the re-training conditions have been satisfied, based on the accumulated error detection results. For example, the first non-volatile memory NVM11 may determine whether an error has been detected for the first data line DQ1, based on respective first sub-results of the first through fourth error detection results EDR1 through EDR4. The first non-volatile memory NVM11 may determine whether an error has been detected for the second data line DQ2, based on respective second sub-results of the first through fourth error detection results EDR1 through EDR4. Because the remaining data lines DQ3 and D4 are similar thereto, detailed descriptions thereof are omitted.

For example, the first non-volatile memory NVM11 may generate a final error detection result FEDR, based on the accumulated error detection results. Because the first sub-result in the first error detection result EDR1 indicates the first value and the first sub-result in the third error detection result EDR3 indicates the first value, a first sub-result of the final error detection result FEDR may indicate the first value 'F'. Because all of the second sub-results in the first through fourth error detection results EDR1 through EDR4 indicate the second value, a second sub-result of the final error detection result FEDR may indicate the second value 'P'. Because the third sub-result in the third error detection result EDR3 indicates the first value, a third sub-result of the final error detection result FEDR may indicate the first value 'F'. Because the fourth sub-result in the fourth error detection result EDR4 indicates the first value 'F', a fourth sub-result of the final error detection result FEDR may indicate the first value 'F'.

The first non-volatile memory NVM11 may count the error detection line number LNUM, based on the final error detection result FEDR. Because the first non-volatile memory NVM11 has detected errors from the first, third, and fourth data lines DQ1, DQ3, and DQ4, the error detection line number LNUM may be '3'. Because the error detection line number LNUM (e.g., '3') is equal to or greater than the threshold value (e.g., '3'), the first non-volatile memory NVM11 may determine that the re-training conditions have been satisfied. In response to the state read command, the first non-volatile memory NVM11 may transmit the state information indicating a transmission error state to the storage controller 110.

While this disclosure contains many specific implementation details, these should not be construed as limitations on the scope of the invention, which is defined by the claims. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. An operation method of a storage device (100) including a storage controller (110) and a non-volatile memory device (120), the operation method comprising:
generating (S110), by the storage controller (110), a plurality of pieces of transmission parity data respectively corresponding to a plurality of data lines (DQ1-DQ4);
transmitting (S120), by the storage controller (110) and through the plurality of data lines (DQ1-DQ4), a write command, data, and the plurality of pieces of transmission parity data to a first non-volatile memory (NVM11) among a plurality of non-volatile memories (NVM11 - NVMmn), the plurality of non-volatile memories (NVM11 - NVMmn) being included in the non-volatile memory device (120);
performing (S130), by the first non-volatile memory (NVM11), a transmission error detection operation with respect to each of the plurality of data lines (DQ1-DQ4), based on each of the plurality of pieces of transmission parity data;
determining (S140, S240), by the first non-volatile memory (NVM11), that re-training execution conditions are satisfied, based on an error detection result generated in the transmission error detection operation;
transmitting (S150), by the storage controller (110), a state read command to the first non-volatile memory (NVM11); and
in response to the state read command and based on the re-training execution conditions being satisfied, transmitting (S160, S260), by the first non-volatile memory (NVM11), state information indicating a transmission error state to the storage controller (110).

2. The operation method of claim 1, wherein determining that the re-training execution conditions are satisfied comprises:
counting a number of data lines (DQ1-DQ4) from which errors are detected, as an error detection line number; and
determining that the re-training execution conditions are satisfied based on the error detection line number being greater than or equal to a predetermined threshold value.

3. The operation method of claim 1 or 2, further comprising performing (S320), by the storage controller (110), a re-training operation on the first non-volatile memory (NVM11) in response to the state information including the transmission error state.

4. The operation method of claim 3, further comprising, while performing (S320) a re-training operation on the first non-volatile memory (NVM11) connected to a first channel (CH1), performing, by the storage controller (110), a read operation or a write operation on a second non-volatile memory (NVM21) connected to a second channel (CH2) among the plurality of non-volatile memories (NVM11 - NVMmn).

5. The operation method of claim 3 or 4, wherein performing (S320) the re-training operation comprises at least one of:
performing (S321) a reference voltage training operation;
performing (S322) a duty cycle correction training operation;
performing (S323) a read training operation; or
performing (S324) a write training operation.

6. The operation method of any preceding claim, further comprising updating (S230), by the first non-volatile memory (NVM11), transmission error information, based on the error detection result,
wherein the transmission error information includes at least one of identifier information of data lines (DQ1-DQ4) from which errors have been detected, or a number of errors detected.

7. The operation method of claim 6, further comprising:
transmitting (S810), by the storage controller (110), a transmission error information request command to the first non-volatile memory (NVM11); and
in response to the transmission error information request command, transmitting (S820), by the first non-volatile memory (NVM11), the transmission error information to the storage controller (110).

8. The operation method of claim 6 or 7, further comprising performing a re-training operation on data lines (DQ1-DQ4) in which errors have been detected, based on the transmission error information.

9. The operation method of any one of claims 6 to 8, further comprising:
transmitting (S850), by the storage controller (110), an oscillator request command of a data strobe signal to the first non-volatile memory (NVM11);
in response to the oscillator request command, transmitting (S860), by the first non-volatile memory (NVM11), an oscillator value to the storage controller (110);
determining (S870), by the storage controller (110), that a re-training operation is to be performed on the first non-volatile memory (NVM11), based on the transmission error information and the oscillator value; and
when it is determined that re-training is to be performed on the first non-volatile memory (NVM11), performing (S880) the re-training operation on the first non-volatile memory (NVM11).

10. The operation method of claim 9, further comprising:
transmitting (S830), by the storage controller (110), an oscillator activation command of a data strobe signal to the first non-volatile memory (NVM11); and
in response to the oscillator activation command, monitoring (S840), by the first non-volatile memory (NVM11), the oscillator value.

11. The operation method of any preceding claim,
wherein transmitting (S120), by the storage controller (110) and through the plurality of data lines (DQ1-DQ4), the write command, the data, and the plurality of pieces of transmission parity data to the first non-volatile memory (NVM11) among the plurality of non-volatile memories (NVM11 - NVMmn) comprises:
transmitting first data and first transmission parity data to the first non-volatile memory (NVM11) through a first data line (DQ1) among the plurality of data lines (DQ1-DQ4), and transmitting second data and second transmission parity data to the first non-volatile memory (NVM11) through a second data line (DQ2) among the plurality of data lines (DQ1-DQ4); and
transmitting third data and third transmission parity data to the first non-volatile memory (NVM11) through the first data line (DQ1) and transmitting fourth data and fourth transmission parity data to the first non-volatile memory (NVM11) through the second data line (DQ2), and
wherein performing the transmission error detection operation with respect to each of the plurality of data lines (DQ1-DQ4) comprises:
performing a first error detection operation on the first data, based on the first transmission parity data, and performing a second error detection operation on the second data, based on the second transmission parity data; and
performing a third error detection operation on the third data, based on the third transmission parity data, and performing a fourth error detection operation on the fourth data, based on the fourth transmission parity data.

12. The operation method of claim 11, wherein determining (S140) that the re-training execution conditions are satisfied comprises:
determining that an error is detected for the first data line (DQ1), based on a result of the first error detection operation and a result of the third error detection operation;
determining that an error is detected for the second data line (DQ2), based on a result of the second error detection operation and a result of the fourth error detection operation;
counting, as an error detection line number, the number of data lines from which errors are detected among the plurality of data lines (DQ1-DQ4); and
determining that the re-training execution conditions are satisfied based on the error detection line number being greater than or equal to a predetermined threshold value.

13. The operation method of any preceding claim, further comprising storing, by the first non-volatile memory (NVM11), the transmission parity data in a memory cell array (123) included in the first non-volatile memory (NVM11).

14. The operation method of any preceding claim, wherein transmitting (S120), by the storage controller (110) and through the plurality of data lines (DQ1-DQ4), the write command, the data, and the plurality of pieces of transmission parity data to the first non-volatile memory (NVM11) among the plurality of non-volatile memories (NVM11 - NVMmn) comprises:
transmitting, by the storage controller (110), the write command, the data, memory parity data, and the plurality of pieces of transmission parity data to the first non-volatile memory (NVM11) through the plurality of data lines (DQ1-DQ4); and
storing, by the first non-volatile memory (NVM11), only the data and the memory parity data in a memory cell array (123).

15. A storage device (100) comprising:
a non-volatile memory device (120) including a plurality of non-volatile memories (NVM11 - NVMmn); and
a storage controller (110) configured to:
generate (S110) a plurality of pieces of transmission parity data respectively corresponding to a plurality of data lines (DQ1-DQ4),
transmit (S120) a write command, data, and the plurality of pieces of transmission parity data to a first non-volatile memory (NVM1 1) among the plurality of non-volatile memories (NVM11 - NVMmn) through the plurality of data lines (DQ1-DQ4), and
transmit (S150) a state read command to the first non-volatile memory (NVM11),
wherein the first non-volatile memory (NVM11) is configured to:
perform a transmission error detection operation (S220) with respect to each of the plurality of data lines (DQ1-DQ4), based on each of the plurality of pieces of transmission parity data,
determine (S140, S240) that re-training execution conditions are satisfied, based on an error detection result generated in the transmission error detection operation, and,
in response to the state read command and based on the re-training execution conditions being satisfied, transmit (S160, S260) state information indicating a transmission error state to the storage controller (110).
